(19) **Europäisches Patentamt / European Patent Office / Office européen des brevets**

(11) **EP 4 728 949 A1**

(12) **EUROPEAN PATENT APPLICATION**
published in accordance with Art. 153(4) EPC

(43) Date of publication:
**22.04.2026  Bulletin 2026/17**

(21) Application number: **24903916.5**

(22) Date of filing: **07.10.2024**

(51) International Patent Classification (IPC):
**A47L 9/28** (2006.01)          **H02J 7/00** (2026.01)
**G01R 19/165** (2006.01)        **G01R 19/30** (2006.01)

(52) Cooperative Patent Classification (CPC):
**A47L 9/28; G01R 19/165; G01R 19/30; H02J 7/00**

(86) International application number:
**PCT/KR2024/015205**

(87) International publication number:
**WO 2025/127349 (19.06.2025 Gazette 2025/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.12.2023  KR 20230182374**
            **07.03.2024  KR 20240032836**

(71) Applicant: **Samsung Electronics Co., Ltd.**
**Suwon-si, Gyeonggi-do 16677 (KR)**

(72) Inventors:
• **KIM, Daehyung**
  **Suwon-si, Gyeonggi-do 16677 (KR)**
• **KIM, Hyeongjun**
  **Suwon-si, Gyeonggi-do 16677 (KR)**

• **HWANG, Seungjoon**
  **Suwon-si, Gyeonggi-do 16677 (KR)**
• **KIM, Minji**
  **Suwon-si, Gyeonggi-do 16677 (KR)**
• **KIM, Yongseok**
  **Suwon-si, Gyeonggi-do 16677 (KR)**
• **OH, Kyungjin**
  **Suwon-si, Gyeonggi-do 16677 (KR)**
• **YUN, Hyeokjoo**
  **Suwon-si, Gyeonggi-do 16677 (KR)**
• **JEONG, Yeonkyu**
  **Suwon-si, Gyeonggi-do 16677 (KR)**
• **JEONG, Jaeshik**
  **Suwon-si, Gyeonggi-do 16677 (KR)**

(74) Representative: **Walaski, Jan Filip et al**
**Venner Shipley LLP**
**200 Aldersgate**
**London EC1A 4HD (GB)**

(54) **CLEANING ROBOT AND METHOD FOR DETECTING OVERHEATING OF CLEANING ROBOT**

(57)    An overheating detection method of a cleaning robot includes, when contact between a first charging terminal of the cleaning robot and a second charging terminal of a station is detected through a first voltage detection circuit, transmitting a charge command to the station, obtaining a heating value between the first charging terminal and the second charging terminal when a voltage is supplied from the station to the cleaning robot according to the charge command, and performing a re-docking operation after the cleaning robot moves away from the station by a predetermined distance when the obtained heating value exceeds a threshold heating value that is a criterion for overheating.

FIG. 1

## Description

Technical Field

An embodiment of the disclosure relate to a cleaning robot docking at a station and an overheating detection method of the cleaning robot.

Background Art

A cordless vacuum cleaner is a type of cleaner that is used by charging a battery included in the vacuum cleaner itself without having to connect a line to an outlet. The cordless vacuum cleaner includes a suction motor that generates suction power, and thus, may suck up foreign materials, such as dust, together with air, from a cleaner head (brush) through the suction power generated in the suction motor, and collect the sucked up foreign materials by separating the sucked up foreign materials from the air.

Compared to wired vacuum cleaners, cordless vacuum cleaners are very convenient to use because it is not necessary to connect a power line. Accordingly, cordless vacuum cleaners are becoming popular. Because a main body of a cordless vacuum cleaner is separated from a station and performs a cleaning function wirelessly, a battery is essential. The battery is mainly charged when the main body of the cordless vacuum cleaner is electrically coupled to the station. In this case, when overheating occurs in a charging terminal for electrically connecting the main body of the cordless vacuum cleaner to the station, the cordless vacuum cleaner may be damaged.

Also, as an example of a cordless vacuum cleaner, a cleaning robot in which a cleaner body automatically performs cleaning while being moved by a driving force of a motor without user intervention has become popular and widely used. The cleaner body of the cleaning robot cleans a floor while traveling in a certain area on its own. The cleaning robot generally includes a rechargeable battery and various sensors that may determine and avoid obstacles while traveling.

In this case, the cleaner body of the cleaning robot is wirelessly driven through the battery. Because the cleaner body may provide various display functions as well as the cleaning function, the battery needs to be continuously charged. A power conversion device can be used to charge the battery. The cleaner body docks at a station including the power conversion device to charge the battery before and after a cleaning operation.

Disclosure of Invention

Solution to Problem

A cleaning robot docking at a station according to an embodiment of the disclosure, includes a first charging terminal configured to charge a battery that powers the cleaning robot, a first voltage detection circuit configured to detect a voltage of the first charging terminal, a first communication interface configured to communicate with the station, a memory configured to store one or more instructions, and at least one processor. The at least one processor may be configured to execute the one or more instructions to perform a plurality of operations including detecting contact between the first charging terminal of the cleaning robot and a second charging terminal of the station through the first voltage detection circuit based on the cleaning robot docking at the station. The at least one processor is configured to execute the one or more instructions to transmit a charge command to the station through the first communication interface based on detecting contact between the first charging terminal and the second charging terminal. The at least one processor is configured to execute the one or more instructions to obtain a heating value between the first charging terminal and the second charging terminal based on a voltage supplied from the station to the cleaning robot according to the charge command. The at least one processor is configured to execute the one or more instructions to perform a re-docking operation after the cleaning robot moves away from the station by a predetermined distance based on determining that the obtained heating value exceeds a threshold heating value that is a criterion for overheating.

A cordless vacuum cleaner, according to an embodiment of the disclosure, is configured to dock at a station. The cordless vacuum cleaner includes a first charging terminal configured to charge a battery that powers the cordless vacuum cleaner, a first voltage detection circuit configured to detect a voltage of the first charging terminal, a first communication interface configured to communicate with the station, a memory configured to store one or more instructions, and at least one processor configured to execute the one or more instructions to perform a plurality of operations. The operations include detecting contact between the first charging terminal of the cordless vacuum cleaner and a second charging terminal of the station through the first voltage detection circuit based on the cordless vacuum cleaner docking at the station, transmitting a charge command to the station through the first communication interface based on detecting contact between the first charging terminal and the second charging terminal, obtaining a heating value between the first charging terminal and the second charging terminal based on a voltage supplied from the station to the cordless vacuum cleaner according to the charge command, and performing an overheating prevention operation based on determining that the obtained heating value exceeds a threshold heating value that is a criterion for overheating.

An overheating detection method of a cleaning robot at a station, according to an embodiment of the disclosure includes detecting contact between a first charging terminal of the cleaning robot and a second charging terminal of the station through a first voltage detection circuit of the cleaning robot based on the cleaning robot docking at the station, transmitting a charge command to the station through a first communication interface of the cleaning robot based on detecting contact between the first charging terminal and the second charging terminal, obtaining a heating value between the first charging terminal and the second charging terminal based on a voltage supplied from the station to charge a battery of the cleaning robot according to the charge command, and performing a re-docking operation after the cleaning robot moves away from the station by a predetermined distance based on determining that the obtained heating value exceeds a threshold heating value that is a criterion for overheating.

Brief Description of Drawings

FIG. 1 is a view for describing a cleaning system, according to an embodiment of the disclosure.
FIG. 2 is a diagram for describing a temperature of a charging terminal when misaligned, according to an embodiment of the disclosure.
FIG. 3A is a view for describing a cleaning robot, according to an embodiment of the disclosure.
FIG. 3B is a view for describing a station, according to an embodiment of the disclosure.
FIG. 4 is a block diagram for describing configurations of a cleaning robot and a station, according to an embodiment of the disclosure.
FIG. 5 is a block diagram for describing a power conversion device, according to an embodiment of the disclosure.
FIG. 6 is a flowchart for describing an overheating detection method of a cleaning robot, according to an embodiment of the disclosure.
FIG. 7 is a circuit diagram used by a cleaning robot to detect contact between a first charging terminal and a second charging terminal, according to an embodiment of the disclosure.
FIG. 8 is a circuit diagram used by a cleaning robot to check whether boosting occurs, according to an embodiment of the disclosure.
FIG. 9 is a circuit diagram for describing an operation in which a cleaning robot calculates a heating value between a first charging terminal and a second charging terminal, according to an embodiment of the disclosure.
FIG. 10 is a diagram for describing a threshold heating value that is a criterion for overheating, according to an embodiment of the disclosure.
FIG. 11 is a diagram for describing overheating and normal heating, according to an embodiment of the disclosure.
FIG. 12 is a flowchart for describing a method by which a cleaning robot transmits a charge command to a station, according to an embodiment of the disclosure.
FIG. 13 is a flowchart for describing a method by which a cleaning robot outputs a notification, according to an embodiment of the disclosure.
FIG. 14 is a view for describing an operation in which a cleaning robot outputs a notification, according to an embodiment of the disclosure.
FIG. 15 is a flowchart for describing a method by which a cleaning robot performs a re-docking operation, according to an embodiment of the disclosure.
FIG. 16 is a view for describing a re-docking operation of a cleaning robot, according to an embodiment of the disclosure.
FIG. 17 is a view for describing an operation in which a cleaning robot interoperates with a server, according to an embodiment of the disclosure.
FIG. 18 is a view for describing an operation in which a cleaning robot outputs a notification through a user terminal, according to an embodiment of the disclosure.
FIG. 19 is a view for describing a cleaning system including a cordless stick cleaner, which may generally be referred to as a cordless vacuum cleaner, according to an embodiment of the disclosure.
FIG. 20 is a view for describing an operation in which a cordless stick cleaner outputs a notification, according to an embodiment of the disclosure.

Mode for the Invention

The terms used herein will be briefly described, and an embodiment of the disclosure will be described in detail.
The terms used herein are general terms currently widely used in the art in consideration of functions in an embodiment of the disclosure, but the terms may vary according to the intention of one of ordinary skill in the art, precedents, or new technology in the art. Also, some terms may be arbitrarily selected by the applicant, and in this case, the meaning of the selected terms will be described in detail in the detailed description of an embodiment of the disclosure. Accordingly, the specific terms used herein should be defined based on the unique meanings thereof and the whole context of the disclosure.

Throughout the disclosure, the expression "at least one of a, b or c" indicates only a, only b, only c, both a and b, both a and c, both b and c, all of a, b, and c, or variations thereof.

When a portion "includes" an element, another element may be further included, rather than excluding the existence of the other element, unless otherwise described. Also, the term such as "... unit" or "... module" used herein refers to a unit that performs at least one function or operation, and the unit may be implemented as hardware or software or as a combination of hardware and software.

It should be appreciated that the blocks in each flowchart and combinations of the flowcharts may be performed by one or more computer programs which include instructions. The one or more computer programs may be stored in a single memory or the one or more computer programs may be divided with different portions stored in different multiple memories.

It is to be understood that the singular forms "a," "an," and "the" include plural referents unless the context clearly dictates otherwise. Thus, for example, reference to "a component surface" includes reference to one or more of such surfaces.

Any of the functions or operations described herein may be processed by one processor or a combination of processors One processor or the combination of processors is circuitry performing processing and includes circuitry such as an application processor (AP), a communication processor (CP), a graphics processing unit (GPU), a neural processing unit (NPU) a microprocessor unit (MPU), a system on chip (SoC), or an integrated circuit (IC).

An embodiment of the disclosure will now be described more fully with reference to the accompanying drawings for one of ordinary skill in the art to be able to perform the embodiment of the disclosure without any difficulty. However, an embodiment of the disclosure may be implemented in many different forms and is not limited to the embodiment described herein. Also, in the drawings, parts irrelevant to the description are omitted in order to clearly describe an embodiment of the disclosure, and like reference numerals denote like elements throughout the disclosure.

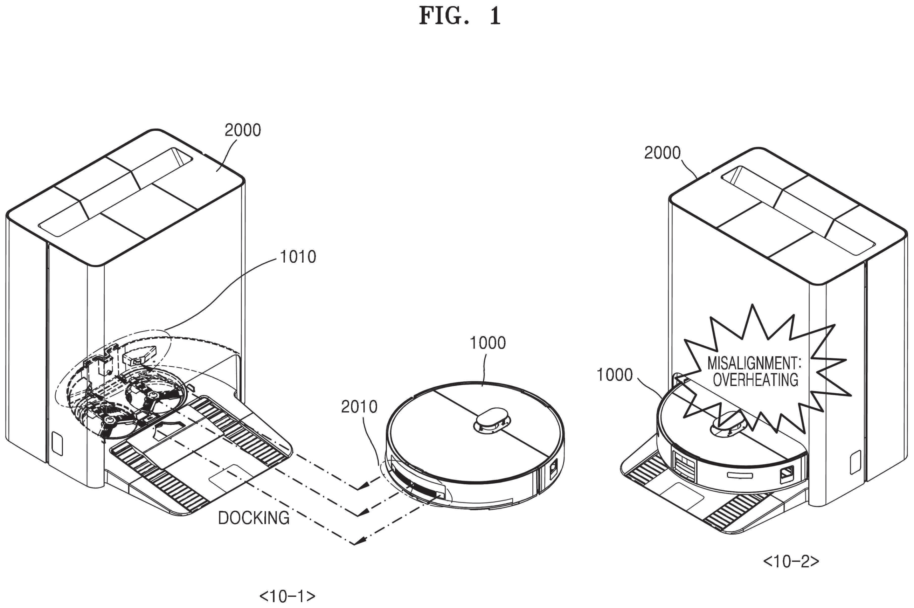

FIG. 1 is a view for describing a cleaning system, according to an embodiment of the disclosure.

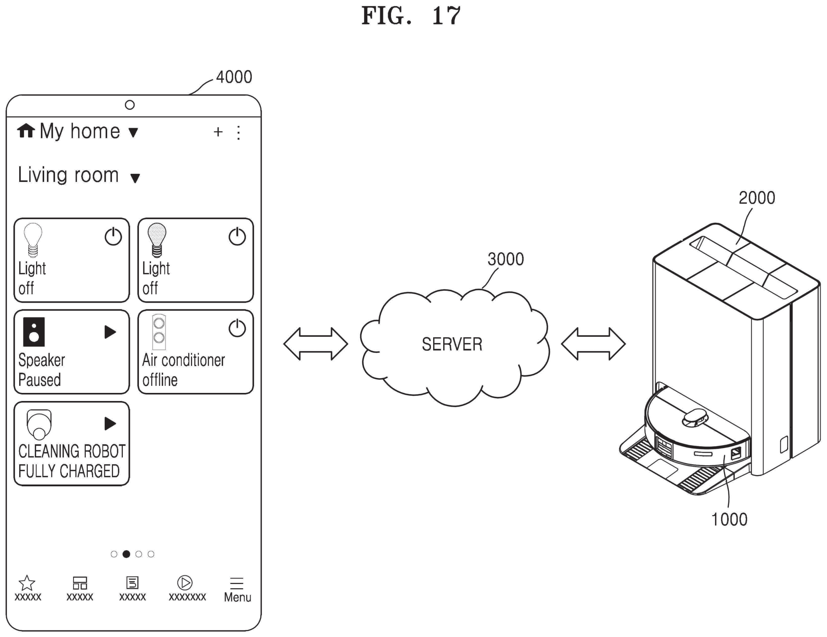

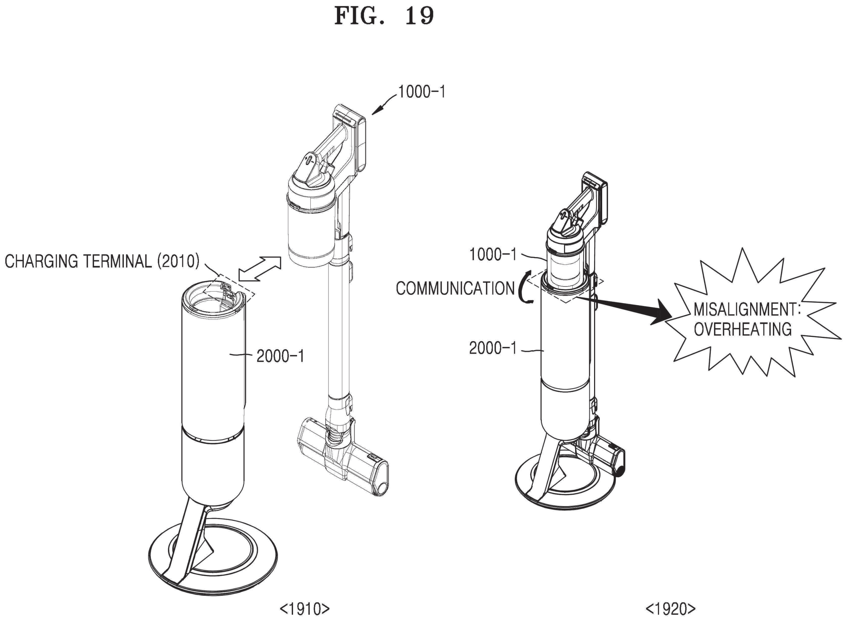

Referring to FIG. 1, a cleaning system according to an embodiment of the disclosure may include, but is not limited to a cleaning robot 1000 and a station 2000. The cleaning system may further include a server (not shown) and a user terminal (now shown) in addition to the cleaning robot 1000 and the station 2000. The cleaning system including the server and the user terminal will be described below in detail with reference to FIG. 17. According to an embodiment of the disclosure, the cleaning system may include a cordless stick cleaner, instead of the cleaning robot 1000. The cleaning system including the cordless stick cleaner will be described below in detail with reference to FIG. 19.

The following will be described assuming that the cleaning system includes the cleaning robot 1000 including a battery and the station 2000 including a power conversion device (e.g., an adaptor) for charging the battery of the cleaning robot 1000.

The cleaning robot 1000 may be a robot device that may perform a cleaning function while moving autonomously. The cleaning robot 1000 may navigate an indoor space by using at least one sensor (e.g., a three-dimensional (3D) sensor, a lidar sensor, a camera, or a fall prevention sensor) and may generate an indoor space map. The cleaning robot 1000 may plan a cleaning path or an operation mode by using an artificial intelligence (AI) function. For example, the cleaning robot 1000 may adjust a suction strength according to the amount of dust in a room or a material of a floor (e.g., a hard floor or a carpet), by using an AI model. When the cleaning robot 1000 recognizes a carpet, the cleaning robot 1000 may automatically lift a wet mop to prevent moisture of the wet mop and contaminants from getting on the carpet. The cleaning robot 1000 may set a concentrated cleaning area. For example, when the cleaning robot 1000 recognizes a stain on the floor during cleaning, the cleaning robot 1000 may return to the station 2000 to heat the wet mop with steam, and then may focus on cleaning the stain on the floor once more. Also, the cleaning robot 1000 may change a cleaning path according to a location of an obstacle (e.g., a cable, a pet defecation pad, a sock, etc.), and may return to the station 2000 to charge the battery according to a remaining battery level or a user command.

The station 2000 may be a device for charging the battery, discharging dust, and storing the cleaning robot 1000. The station 2000 may also be referred to as a charger or a clean station.

The cleaning robot 1000 and the station 2000 may be electrically coupled to each other through a charging terminal. For example, a charging terminal of the cleaning robot 1000 (hereinafter, referred to as a first charging terminal 1010) and a charging terminal of the station 2000 (hereinafter, referred to as a second charging terminal 2010) may be electrically coupled to each other. The cleaning robot 1000 may be aligned with and may dock at the station 2000 so that the first charging terminal 1010 and the second charging terminal 2010 are electrically coupled to each other. When the cleaning robot 1000 normally docks at the station 2000 and the first charging terminal 1010 of the cleaning robot 1000 and the second charging terminal 2010 of the station 2000 directly contact each other, the battery of the cleaning robot 1000 may be charged through a charging sequence. In the specification, the term 'charging terminal' collectively refers to the first charging terminal 1010 of the cleaning robot 1000 and the second charging terminal 2010 of the station 2000 unless otherwise described.

When the cleaning robot 1000 docks at the station 2000 and the first charging terminal 1010 and the second charging terminal 2010 are electrically connected to each other but the cleaning robot 1000 and the station 2000 are misaligned with each other or there is a foreign material between the charging terminals, the charging terminals may be overheat. For example, when the cleaning robot 1000 and the station 2000 are well aligned with each other and dock appropriately, contact resistance between the first charging terminal 1010 of the cleaning robot 1000 and the second charging terminal 2010 of the station 2000 may be significantly low, such as at a certain value or lower. However, when the cleaning robot 1000 and the station 2000 are not well aligned with each other and contact between the charging terminals is not properly made, contact resistance between the first charging terminal 1010 of the cleaning robot 1000 and the second charging terminal 2010 of the station 2000 may increase. In this case, when the battery of the cleaning robot 1000 is charged, heat may be generated due to abnormally high contact resistance, which may cause damage to a component near the charging terminal or damage to the charging terminal. Hereinafter, a case where the cleaning robot 1000 and the station 2000 are well aligned and contact resistance between the charging terminals is quite low (e.g., almost $0\,\Omega$) may be referred to as a 'normal alignment state', and a case where the cleaning robot 1000 and the station 2000 are not well aligned and contact resistance increases may be referred to as a 'misalignment state'.

When the cleaning robot 1000 normally docks at the station 2000 and the battery in the cleaning robot 1000 begins to be charged, the station 2000 uses appropriate power (= voltage X current) to charge the battery according to the capacity of the power conversion device (also known as an adaptor or a switched mode power supply (SMPS)). When the cleaning robot 1000 normally docks at the station 2000 and starts a charging sequence, because contact resistance between the charging terminals is within several $m\Omega$, abnormal overheating does not occur in the charging terminals during charging. However, when the cleaning robot 1000 incompletely docks at the station 2000 for some reason, because contact resistance between the charging terminals increases to several $\Omega$, power corresponding to P=I*I*R is released from the charging terminals.

For example, when the power conversion device (also known as adaptor or SMPS) of the station 2000 has a specification of 25.25V/2.5A and the cleaning robot 1000 incompletely docks at the station 2000 and thus contact resistance between the charging terminals is $2\Omega$, 12.5 W (=2.5 x 2.5 x 2) from among the total battery charging power (63 W) is changed into heat energy at the charging terminals, causing overheating at the charging terminals.

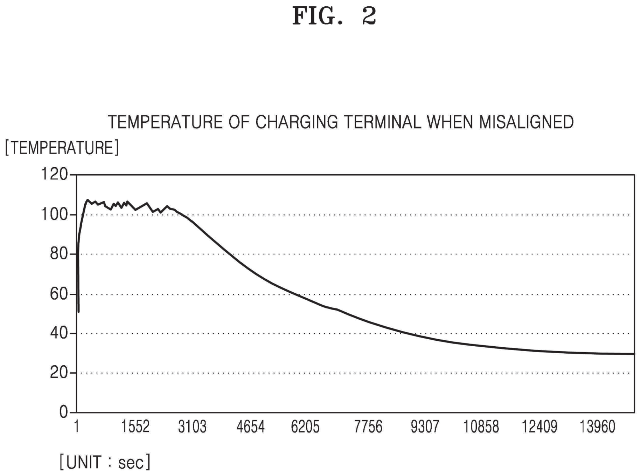

Referring to FIG. 2, overheating at a charging terminal may increase a temperature of the charging terminal to 100°C or higher within a few minutes. Once the overheating occurs, an injection molding product surrounding the charging terminal, a component around the charging terminal, and/or the charging terminal itself may be deformed by heat, which may lead to a fire in the cleaning robot 1000 or the station 2000.

Because the cleaning robot 1000 is used in a variety of environments due to product characteristics, misalignment between charging terminals or a situation where a foreign material is attached to a charging terminal may easily occur. Accordingly, according to an embodiment of the disclosure, the cleaning robot 1000 may calculate a charging terminal heating value by applying a charging terminal voltage and current detection algorithm and may perform an overheating prevention operation when the charging terminal heating value exceeds a threshold heating value that is a criterion for overheating. For example, the cleaning robot 1000 may stop charging and perform a re-docking after moving away from the station 2000 by a predetermined distance to be re-aligned with the station 2000.

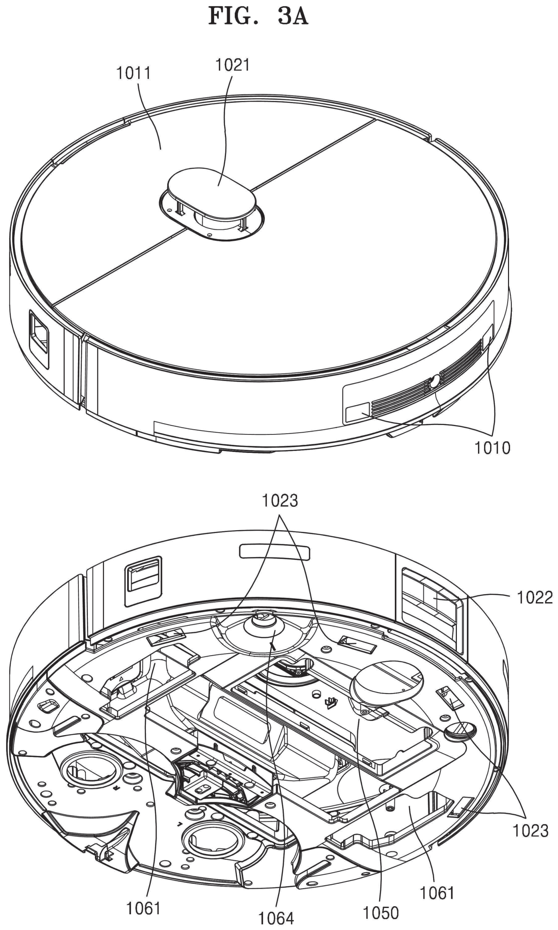

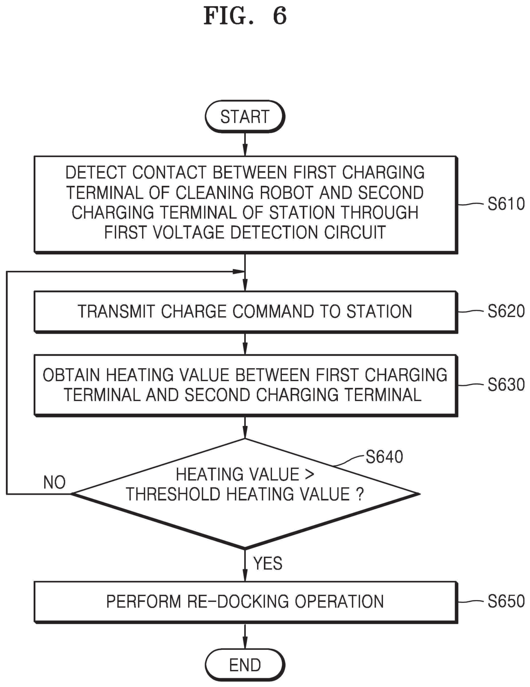

An operation in which the cleaning robot 1000 detects an overheating state and performs re-alignment with the station 2000 will be described below in detail with reference to FIG. 6, and a configuration of the cleaning robot 1000 will be described in more detail with reference to FIG. 3A.

FIG. 3A is a view for describing the cleaning robot 1000, according to an embodiment of the disclosure.

Referring to FIG. 3A, the cleaning robot 1000 may include the first charging terminal 1010 on a rear surface. When the first charging terminal 1010 is located on the rear surface, the cleaning robot 1000 may move backward and may dock at the station 2000. The first charging terminal 1010 includes a conductor for electrical connection with the station 2000. Although the first charging terminal 1010 according to an embodiment of the disclosure is attached to the rear surface of the cleaning robot 1000 in FIG. 3A, the disclosure is not limited thereto. According to a design of the cleaning robot 1000, the first charging terminal 1010 may be attached to a bottom surface of the cleaning robot 1000, may be attached to a front surface of the cleaning robot 1000, or may be attached to a side surface of the cleaning robot 1000.

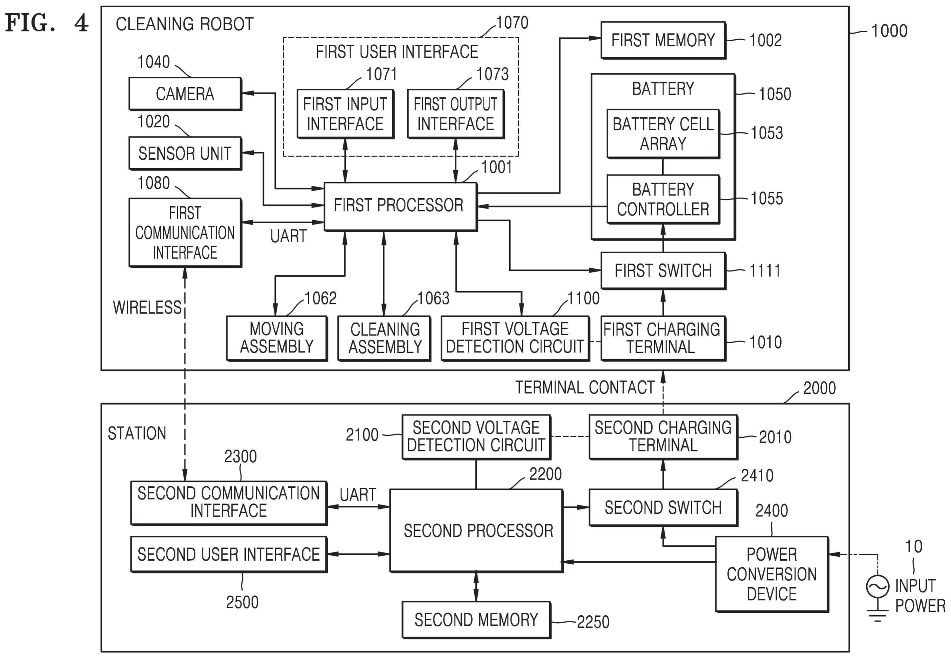

The cleaning robot 1000 may include a lidar sensor 1021 on a top surface, may include an obstacle detection sensor (3D sensor) 1022 on a side surface, and may include a fall prevention sensor 1023 on the bottom surface contacting a surface to be cleaned, but the disclosure is not limited thereto. The cleaning robot 1000 may include a printed board assembly (PBA) or a printed circuit board assembly 1011 therein. The PBA 1011 may be connected to the first charging terminal 1010 and may include at least one processor, a memory, and a voltage detection circuit. The cleaning robot 1000 may further include driving wheels 1061, a brush 1064, and a battery 1050. Each element will be described below with reference to FIG. 4.

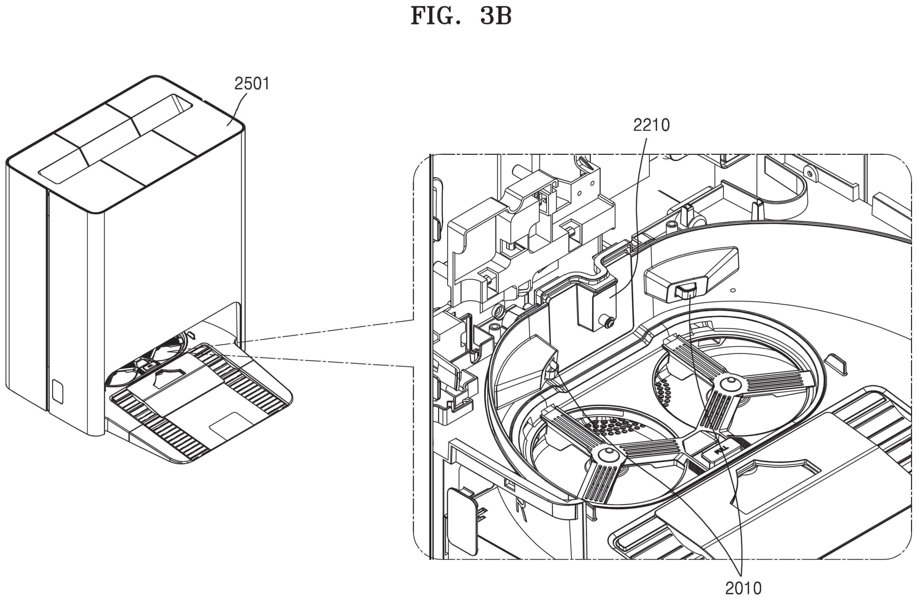

FIG. 3B is a view for describing the station 2000, according to an embodiment of the disclosure.

Referring to FIG. 3B, the second charging terminal 2010 may be provided in the station 2000. Also, a PBA 2210 may be provided between a positive (+) charging terminal and a negative (-) charging terminal. The PBA 2210 may be connected to the second charging terminal 2010 and may include a voltage detection circuit, at least one processor, and a memory.

According to an embodiment of the disclosure, the second charging terminal 2010 may be located at a position where the second charging terminal 2010 may contact the first charging terminal 1010 when the cleaning robot 1000 docks at the station 2000. For example, when the first charging terminal 1010 is located on the rear surface of the cleaning robot 1000, the second charging terminal 2010 may be located to face forward. When the first charging terminal 1010 is located on the bottom surface of the cleaning robot 1000, the second charging terminal 2010 may be located to face upward.

According to an embodiment of the disclosure, the station 2000 may include a state indicator light 2501. The state indicator light 2501 may include, but is not limited to, a plurality of light emitting diodes (LEDs). The station 2000 may display a state of charge and a docking state of the cleaning robot 1000 by controlling a blinking period, a color, etc. of the state indicator light 2501. For example, when the battery 1050 of the cleaning robot 1000 is being charged, the station 2000 may turn on the state indicator light 2501 in orange, and when the battery 1050 is fully charged, the station 2000 may turn on the state indicator light 2501 in green. Also, when the battery 1050 of the cleaning robot 1000 is being charged, the station 2000 may blink the state indicator light 2501 at a certain cycle, and when the battery 1050 is fully charged, the station 2000 may stop blinking the state indicator light 2501.

Configurations of the cleaning robot 1000 and the station 2000 will be described in more detail with reference to FIG. 4.

FIG. 4 is a block diagram for describing configurations of the cleaning robot 1000 and the station 2000, according to an embodiment of the disclosure.

The cleaning robot 1000 may include a first processor 1001, a first memory 1002, the first charging terminal 1010, a first switch 1111, a sensor unit 1020, a camera 1040, the battery 1050, a first user interface 1070, a first communication interface 1080, a moving assembly 1062, a cleaning assembly 1063, and a first voltage detection circuit 1100. However, at least one of the elements shown in FIG. 4 may not be essential. The cleaning robot 1000 may include more or fewer elements than those illustrated in FIG. 4. Each element will be described.

The first processor 1001 controls an overall operation of the cleaning robot 1000. The first processor 1001 may control elements of the cleaning robot 1000 by executing a program stored in the first memory 1002. The first processor 1001 may be at least one processor. For example, the first processor 1001 may be one processor or a plurality of processors.

The first processor 1001 according to an embodiment of the disclosure may include at least one of a central processing unit (CPU), a graphics processing unit (GPU), an accelerated processing unit (APU), a many integrated core (MIC), a digital signal processor (DSP), or a neural processing unit (NPU). The first processor 1001 may be implemented in the form of an integrated system-on-chip (SoC) including one or more electronic components. The first processor 1001 may be referred to as a microprocessor controller (MICOM), a microprocessor unit (MPU), or a micro-controller unit (MCU). The first processor 1001 according to an embodiment of the disclosure may be implemented as a single core processor or a multicore processor.

According to an embodiment of the disclosure, the first processor 1001 may include an analog-digital conversion unit therein. Although not shown in FIG. 4, when there is no analog-digital conversion unit in the first processor 1001, the cleaning robot 1000 may include a separate analog-digital conversion IC. When the first processor 1001 includes an analog-digital conversion unit therein, the first processor 1001 may include an analog-digital conversion input port for receiving an analog signal to be converted into a digital signal. In an embodiment of the disclosure, a plurality of analog-digital conversion input ports may be provided. The analog-digital conversion input port may receive an analog value corresponding to a voltage change from the first voltage detection circuit 1100. The received analog value may be converted into a digital value that may be processed by the first processor 1001. That is, the first processor 1001 may measure a voltage value of the first charging terminal 1010 through the first voltage detection circuit 1100.

According to an embodiment of the disclosure, the first processor 1001 may obtain a discharge current value of the battery 1050 or a charge current value of the battery 1050 through a current detection circuit (not shown). The current detection circuit may be located in the battery 1050 or may be separately provided outside the battery 1050. The following will be described assuming that the current detection circuit is located in the battery 1050. The current detection circuit may include, but is not limited to, a shunt resistor.

According to an embodiment of the disclosure, the first processor 1001 may obtain a charging terminal heating value by using a charging terminal voltage and charging terminal current. The charging terminal voltage may refer to a voltage applied to contact resistance formed between the first charging terminal 1010 and the second charging terminal 2010. For example, the charging terminal voltage may be a difference between a voltage value of the first charging terminal 1010 obtained through the first voltage detection circuit 1100 and a voltage value of the second charging terminal received from the station 2000. The charging terminal current may be a sum of a charging current value of the battery 1050 and a discharge current value of the battery 1050. The first processor 1001 may determine whether the first charging terminal 1010 is in an overheating state, by comparing a charging terminal heating value with a threshold heating value that is a criterion for overheating.

When it is determined that the first charging terminal 1010 is in an overheating state, the first processor 1001 may perform an overheating prevention operation. For example, when it is determined that the first charging terminal 1010 is overheated, the first processor 1001 may drive the cleaning robot 1000 and perform an overheating preventing operation of moving the cleaning robot 1000 away from the station 2000 by a predetermined distance. The predetermined distance may be, for example, a distance at which the first charging terminal 1010 may be electrically insulated from the second charging terminal 2010. The first processor 1001 may separate the cleaning robot 1000 from the station 2000 by a predetermined distance or more and then may perform a docking operation (hereinafter, referred to as a re-docking operation) of electrically reconnecting the cleaning robot 1000 to the station 2000.

According to an embodiment of the disclosure, an overheating prevention operation of the first processor 1001 may be performed in another manner. For example, when it is determined that the first charging terminal 1010 is overheated, the first processor 1001 may control the first switch 1111 to be turned off to cut off electrical connection between the first charging terminal 1010 and the battery 1050. Due to this operation, because electrical connection between a power conversion device 2400 of the station 2000 and the battery 1050 of the cleaning robot 1000 is cut off, damage to a component of the cleaning robot 1000 due to overheating of the first charging terminal 1010 (or the second charging terminal 2010 of the station 2000) may be prevented. Throughout this specification, when the first charging terminal 1010 is overheated, it may also mean that the second charging terminal 2010 of the station 2000 is overheated. This is because the first charging terminal 1010 and the second charging terminal 2010 are in close contact to a considerable extent at a time when overheating occurs.

According to an embodiment of the disclosure, when it is determined that the first charging terminal 1010 is in an overheating state, the first processor 1001 may communicate with a second communication interface 2300 of the station 2000 through the first communication interface 1080 to notify the station 2000 that the first charging terminal 1010 (or the second charging terminal 2010 of the station 2000 contacting the first charging terminal 1010) is in an overheating state (hereinafter, referred to as overheating notification).

In an embodiment of the disclosure, the station 2000 receiving the overheating notification from the cleaning robot 1000 may perform an overheating prevention operation. For example, the second processor 2200 of the station 2000 may turn off a second switch 2410 of the station 2000 based on the overheating notification received from the cleaning robot 1000. When the second switch 2410 is turned off, electrical connection between the power conversion device 2400 and the second charging terminal 2010 may be cut off

The first memory 1002 may store or retain a program and/or data for controlling the cleaning robot 1000. The first memory 1002 stores or records various information, data, instructions, and programs operation of the cleaning robot 1000. The first memory 1002 may store temporary data generated while a control signal for controlling elements included in the cleaning robot 1000 is generated. The first memory 1002 may include at least one of a volatile memory or a nonvolatile memory, or a combination thereof.

The cleaning robot 1000 may include the first charging terminal 1010 electrically connected to the second charging terminal 2010. The battery 1050 may be charged with a direct current (DC) voltage transmitted through the first charging terminal 1010. In an embodiment of the disclosure, the first switch 1111 for cutting off power may be included between the first charging terminal 1010 and the battery 1050, but is not essential.

When the cleaning robot 1000 moves in a space to be cleaned, the sensor unit 1020 senses the space so that the cleaning robot 1000 does not reach a state where cleaning is impossible due to an obstacle or a falling. The sensor unit 1020 may include, but is not limited to, the obstacle detection sensor (3D sensor) 1022, the lidar sensor 1021, a bumper sensor, the fall prevention sensor 1023, an ultrasonic sensor, and a travel distance detection sensor (e.g., an encoder). For example, the sensor unit 1020 may include an infrared sensor. The cleaning robot 1000 may detect an infrared signal emitted from the station 2000 by using then infrared sensor and may dock while being aligned with the station 2000.

The camera 1040 may be an image sensor for obtaining an image of a cleaning space. Multiple cameras 1040 may be located in the cleaning robot 1000 according to an implementation example.

The battery 1050 may be referred to as a battery pack and may include a battery cell array 1053 that is charged with electricity and a battery controller 1055 for controlling the battery 1050. The battery controller 1055 may include a battery management system (BMS). The battery controller 1055 may perform inter-integrated circuit (I2C) communication with the first processor 1001. According to an embodiment of the disclosure, the battery 1050 may include a current detection circuit (e.g., a shunt resistor), and the battery controller 1055 may sense charge current or discharge current of the battery cell array 1053 through the current detection circuit. The battery controller 1055 may transmit a charge current value and a discharge current value of the battery cell array 1053 to the first processor 1001 through I2C communication.

The first user interface 1070 may include a first input interface 1071 through which a command may be input to the cleaning robot 1000 and a first output interface 1073 through which information is displayed to a user. The first input interface 1071 may be a user input interface capable of touch recognition or a microphone capable of voice input. The first output interface 1073 may be, but is not limited to, an LCD or LED display or a speaker. The first output interface1073 may display various information indicating a state of the cleaning robot 1000 to the user. For example, when the first charging terminal 1010 and/or the second charging terminal 2010 is overheated, the first output interface 1073 may display or output voice information on whether a charging terminal is overheated, and may also display location information about which charging terminal from among a positive (+) charging terminal and a negative (-) charging terminal is overheated according to an embodiment of the disclosure. Also, the first output interface 1073 may provide information such as an operation state of the cleaning robot 1000, a charging amount, and whether the cleaning robot 1000 is charged.

The first communication interface 1080 may communicate with an external device. For example, the cleaning robot 1000 may communicate with the station 2000 or a server through the first communication interface 1080. According to an embodiment of the disclosure, the cleaning robot 1000 may transmit a charge command (boost command), a voltage value reply command of the second charging terminal 2010, etc. to the station 2000 through the first communication interface 1080. When the first charging terminal 1010 or the second charging terminal 2010 is in an overheating state, the cleaning robot 1000 may transmit information (re-docking notification) indicating that re-docking is performed due to misalignment with the station 2000 to the server through the first communication interface 1080.

The first communication interface 1080 may include a short-range wireless communication interface and a long-range wireless communication interface. Examples of the short-range wireless communication interface may include, but are not limited to, an infrared data association (IrDA) communication interface, a Bluetooth communication interface, a Bluetooth low energy (BLE) communication interface, a near-field communication (NFC) unit, a wireless local area network (WLAN) (Wi-Fi) communication interface, a Zigbee communication interface, a Wi-Fi direct (WFD) communication interface, an ultra-wideband (UWB) communication interface, and an Ant+ communication interface. The first communication interface 1080 may include a wired communication interface.

The moving assembly 1062 moves a main body of the cleaning robot 1000. The moving assembly 1062 may include a pair of wheels that move the cleaning robot 1000 forward and backward and rotate the cleaning robot 1000, a wheel motor that applies a moving force to each wheel, and a caster wheel that is provided in front of the main body and rotates to change an angle according to a state of a floor on which the cleaning robot 1000 moves. The moving assembly 1062 moves the cleaning robot 1000 under the control by the first processor 1001. The first processor 1001 determines a travel route and controls the moving assembly 1062 to move the cleaning robot 1000 along the determined travel route.

The cleaning assembly 1063 may include a main brush assembly provided on the bottom of the main body and configured to sweep or scatter dust on the floor or suck up the swept or scattered dust, and a side brush assembly provided on the bottom of the main body to protrude outward and configured to sweep dust from an area other than an area cleaned by the main brush assembly and transfer the swept dust to the main brush assembly. Also, the cleaning assembly 1063 may include a vacuum cleaning module that performs vacuum suction or a wet mop cleaning module that performs wet mop cleaning.

The first voltage detection circuit 1100 is a circuit for detecting a voltage value of the first charging terminal 1010. The first voltage detection circuit 1100 may include a voltage division circuit. When the cleaning robot 1000 docks at the station 2000, the first processor 1001 may detect contact between the first charging terminal 1010 and the second charging terminal 2010 by obtaining a certain voltage value (e.g., 8 V) through the first voltage detection circuit 1100. When a charge command (also referred to as a boost command) is transmitted to the station 2000, the first processor 1001 may determine whether a supply voltage of the station 2000 has been boosted by using the first voltage detection circuit 1100. For example, the first processor 1001 may determine whether a voltage of the first charging terminal 1010 has been boosted from 8 V to 17 V. The first processor 1001 may continuously monitor a heating value (hereinafter, referring to as a charging terminal heating value) between the first charging terminal 1010 and the second charging terminal 2010 by periodically measuring (e.g., at an interval of 1.6 seconds) a voltage value of the first charging terminal 1010 through the first voltage detection circuit 1100 during charging.

The station 2000 may include a second processor 2200, a second memory 2250, the second communication interface 2300, the power conversion device 2400, a second user interface 2500, the second charging terminal 2010, the second switch 2410, and a second voltage detection circuit 2100. However, at least one of the elements illustrated in FIG. 4 may not be essential. The station 2000 may include more or fewer elements than those illustrated in FIG. 4. For example, the station 2000 may further include a suction motor that generates a suction force to discharge dust of the cleaning robot 1000, a collection unit (e.g., a dust bag) in which dust of the cleaning robot 1000 is collected, a filter unit (e.g., a motor filter or a high-efficiency particulate air (HEPA) filter) that filters out ultra-fine dust not collected in the collection unit, a steam unit that sprays steam, and a plurality of infrared modules that guide homing and docking of the cleaning robot 1000. Each element will be described.

The second processor 2200 controls an overall operation of the station 2000. The second processor 2200 may control elements of the station 2000 by executing a program stored in the second memory 2250. The second processor 2200 may be at least one processor. For example, the second processor 2200 may be one processor or a plurality of processors.

The second processor 2200 according to an embodiment of the disclosure may include at least one of a central processing unit (CPU), a graphics processing unit (GPU), an accelerated processing unit (APU), a many integrated core (MIC), a digital signal processor (DSP), or a neural processing unit (NPU). The second processor 2200 may be implemented in the form of an integrated system-on-chip (SoC) including one or more electronic components. The second processor 2200 may be referred to as a microprocessor controller (MICOM), a microprocessor unit (MPU), or a micro-controller unit (MCU). The second processor 2200 according to an embodiment of the disclosure may be implemented as a single core processor or a multicore processor.

The second memory 2250 may store a program (e.g., one or more instructions) using which the second processor 2200 generally controls an operation of the station 2000, and may store input/output data. For example, the second memory 2250 may store, but is not limited to, software related to control of the station 2000, charging terminal overheating state data, charging terminal overheating history data, charging terminal overheating location information data, error occurrence data (e.g., failure history data), a type of an operation event, and information related to charging of the battery 1050 (e.g., a charging interval, last compensation charging time point data, and a charging level of the battery 1050 during recent compensation charging). The second memory 2250 may also store data received from the cleaning robot 1000. For example, the second memory 2250 may store product information (e.g., identification information and model information) of the cleaning robot 1000 mounted on the station 2000, version information of software installed on the cleaning robot 1000, error occurrence data (failure history data) of the cleaning robot 1000, and information related to charging of the battery 1050.

The second memory 2250 may include at least one type of storage medium of a flash memory type storage unit, a hard disk type storage unit, a multimedia card micro type storage unit, a card type memory (e.g., an SD or XD memory), a random-access memory (RAM), a static random-access memory (SRAM), a read-only memory (ROM), an electrically erasable programmable read-only memory (EEPROM), a programmable read-only memory (PROM), a magnetic memory, a magnetic disk, or an optical disk. Programs stored in the second memory may be classified into a plurality of modules according to their functions.

The station 2000 may include the second communication interface 2300 for performing communication with an external device. For example, the station 2000 may communicate with the cleaning robot 1000, a server (not shown), and/or a user terminal (not shown) through the second communication interface 2300. In this case, the second communication interface 2300 may communicate with the server through a first communication method (e.g., a Wi-Fi communication method) and may communicate with the cleaning robot 1000 through a second communication method (e.g., an infrared communication method).

The second communication interface 2300 may include a short-range wireless communication interface and a long-range wireless communication interface. Examples of the short-range wireless communication interface may include, but are not limited to, an infrared data association (IrDA) communication interface, a Bluetooth communication interface, a Bluetooth low energy (BLE) communication interface, a near-field communication (NFC) unit, a wireless local area network (WLAN) (Wi-Fi) communication interface, a Zigbee communication interface, a Wi-Fi direct (WFD) communication interface, an ultra-wideband (UWB) communication interface, and an Ant+ communication interface. The long-range communication interface may be used to enable the station 2000 to remotely communicate with the server or the user terminal. Examples of the long-range wireless communication interface may include the Internet, a computer network (e.g., a local area network (LAN) or a wide area network (WAN)), and a mobile communication interface. Examples of the mobile communication interface may include, but are not limited to, a 3G module, a 4G module, a 5G module, an LTE module, an NB-IoT module, and an LTE-M module.

The second communication interface 2300 may transmit data to the processor 2200 through, for example, a universal asynchronous receiver/transmitter (UART) protocol, which is asynchronous communication, but a communication method is not limited thereto.

The second user interface 2500 of the station 2000 may include a second output interface and a second input interface. The second input interface may be a means through which the user may input a command to the station 2000. The second input interface may include, but is not limited to, a touchscreen, a microphone, and physical buttons. The second input interface may include a cleaning start operation button, a dust discharge button, a mode selection button, etc. The second output interface may include, but is not limited to, a display of an LED, LCD, or touchscreen or a voice output device (e.g., a speaker). The second output interface may display, but is not limited to, a charging amount of the battery 1050 of the cleaning robot 1000, software update progress information, operation event information, and overheating information of the cleaning robot 1000.

The second voltage detection circuit 2100 is a circuit for detecting a voltage value of the second charging terminal 2010. The second voltage detection circuit 2100 may include a voltage division circuit. When the second processor 2200 receives a voltage value reply command of the second charging terminal 2010 from the cleaning robot 1000, the second processor 2200 may transmit a voltage value of the second charging terminal 2010 detected through the second voltage detection circuit 2100 to the cleaning robot 1000. The second processor 2200 may continuously detect a voltage value of the second charging terminal 2010 through the second voltage detection circuit 2100 during charging and may periodically transmit the voltage value of the second charging terminal 2010 to the cleaning robot 1000.

The power conversion device 2400 is a device that receives alternating current (AC) power and converts the AC power into DC power. The power conversion device 2400 may include a power conversion IC such as a pulse width modulation (PWM) controller for power consumption. The power conversion device 2400 may generate a DC voltage for charging the battery 1050 included in the cleaning robot 1000. When the cleaning robot 1000 is electrically coupled to the station 2000, DC power generated by the power conversion device 2400 may be supplied to the battery 1050 of the cleaning robot 1000 through the first charging terminal 1010 of the cleaning robot 1000 and the second charging terminal 2010 of the station 2000 to charge the battery 1050. The second charging terminal 2010 may be electrically connected to the first charging terminal 1010 to charge the battery 1050 included in the cleaning robot 1000. The second charging terminal 2010 may be connected to the power conversion device 2400 and may supply a DC voltage (e.g., 17 V) output from the power conversion device 2400 to the battery 1050 through the first charging terminal 1010. For example, when the second processor 2200 receives a charge command (boost command) from the cleaning robot 1000, the second processor 2200 may turn on the second switch 2410 to supply a voltage output from the power conversion device 2400 to the battery 1050 through the second charging terminal 2010 and the first charging terminal 1010.

In an embodiment of the disclosure, the second switch 2410 that may cut off a DC voltage generated in the power conversion device 2400 may be included between the power conversion device 2400 and the second charging terminal 2010, but is not essential.

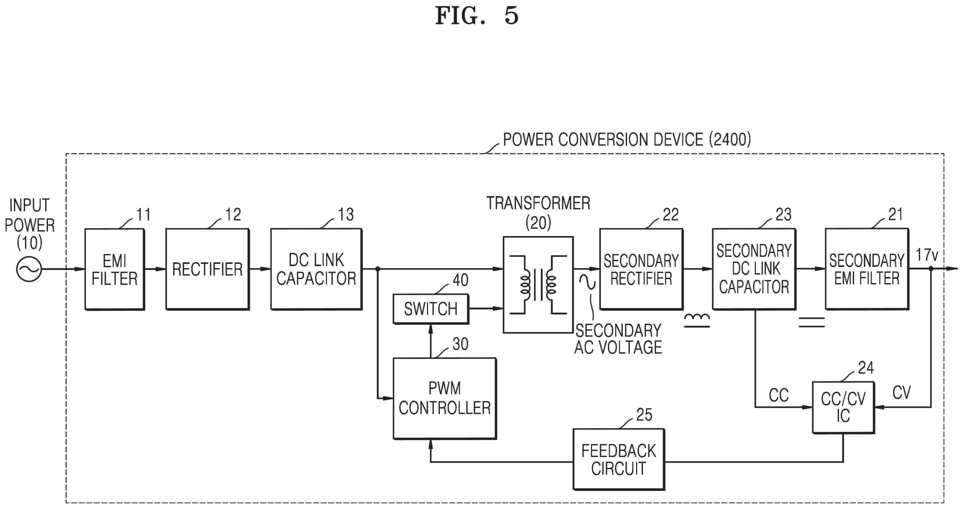

The power conversion device 2400 may receive input power 10 supplied to the station 2000 and may convert an AC voltage into a DC voltage. The power conversion device 2400 may include a switching device for AC-DC conversion and a PWM controller for driving the switching device. The switching device included in the power conversion device 2400 may be one of, but not limited to, a field-effect transistor (FET), a metal oxide field-effect transistor (MOSFET), an insulated gate bipolar mode transistor (IGBT), and a transistor (TR) The power conversion device 2400 may be located on a bottom surface of the station 2000 that may be connected to the input power 10, but the disclosure is not limited thereto and the power conversion device 2400 may be located on any surface of the station 2000. The power conversion device 2400 will be described in more detail with reference to FIG. 5.

FIG. 5 is a block diagram for describing the power conversion device 2400, according to an embodiment of the disclosure.

Referring to FIG. 5, the power conversion device 2400 receives the input power 10 that is an AC voltage. A magnitude of the AC voltage may vary according to a specification, but may be any one in a range of 90 V to 210 V. However, because there are countries using lower or higher AC voltage values, the above values are only approximate values and are not intended to limit the range of the AC voltage.

The power conversion device 2400 is a device for converting an AC voltage received through the input power 10 into a DC voltage (e.g., DC 5C and/or DC 17 V). The power conversion device 2400 may be referred to as an adaptor or a switched mode power supply (SMPS).

An AC voltage from the input power 10 has noise removed through an EMI filter 11 and is converted into a DC voltage through a rectifier 12. The rectifier 12 mainly includes a diode, but the disclosure is not limited thereto and the rectifier 12 may include a switching device such as a thyristor or an insulated gate bipolar mode transistor (IGBT). The DC voltage converted through the rectifier 12 is smoothed through a DC link capacitor 13. The DC voltage at both ends of the DC link capacitor 13 may be converted back into an AC voltage of a desired magnitude and a desired frequency by PWM switching a switch 40 under the control by a PWM controller 30. The converted AC voltage passes through a transformer 20 for insulation, filtering, and/or voltage magnitude change. An output of a secondary side of the transformer 20 becomes a secondary AC voltage, and the secondary AC voltage passes through the secondary rectifier 22 and is rectified back into a secondary DC voltage. The secondary DC voltage is smoothed through a secondary DC link capacitor 23. The smoothed secondary DC voltage passes through the secondary EMI filter 21 to remove noise and the DC voltage (e.g., DC 17 V) passing through a secondary EMI filter 21 may pass through the first and second charging terminals 1010 and 2010 to charge the battery 1050 of the cleaning robot 1000.

In FIG. 5, a CC/CV IC 24 is a circuit or an integrated circuit (IC) for controlling conversion to a constant current (CC) mode or a constant voltage (CV) mode during charging of the battery 1050. As a discharging amount increases, a voltage of the battery 1050 may be lower than a full-charge voltage. Accordingly, when the battery 1050 is charged, the battery 1050 is charged in a CC mode, under the control by the CC/CV IC 24, until a certain percentage (%) of the full-charge voltage (e.g., 80% of the full-charge voltage), and after that, is charged in a CV mode. The CC/CV IC 24 is in charge of such conversion to the CC mode or the CC mode.

A feedback circuit 25 may monitor an output terminal (e.g., 17 V) for charging the battery 1050 and may provide feedback to the PWM controller 30 so that a charge output to the battery 1050 is constant. For example, when a charging voltage to the battery 1050 is 17 V and a current charging voltage is 20 V, the feedback circuit 25 provides overvoltage feedback to the PWM controller 30. The PWM controller 30 receiving the overvoltage feedback controls an output voltage of the power conversion device 2400 to be lowered by reducing switching of the switch 40. In contrast, when a charging voltage to the battery 1050 is currently 15 V, the feedback circuit 25 provides low-voltage feedback to the PWM controller 30. The PWM controller 30 receiving the low-voltage feedback controls an output voltage of the power conversion device 2400 to be increased by increasing switching of the switch 40.

The PWM controller 30 is in charge of controlling an output of the power conversion device 2400 and may have an IC form pre-manufactured by a chip manufacturer. The PWM controller 30 controls the switch 40 to perform PWM switching.

A method by which the cleaning robot 1000 detects overheating of a charging terminal will be described in detail with reference to FIG. 6.

FIG. 6 is a flowchart for describing an overheating detection method of the cleaning robot 1000, according to an embodiment of the disclosure.

Referring to FIG. 6, the overheating detection method of the cleaning robot 1000 may include operations S610 to S650. In an embodiment of the disclosure, operations S610 to S650 may be executed by at least one processor included in the cleaning robot 1000. The overheating detection method of the cleaning robot 1000 is not limited to that of FIG. 6, and in one or more embodiments of the disclosure, the overheating detection method of the cleaning robot 1000 may further include operations not shown in FIG. 6 or some operations may be omitted.

In operation S610, as the cleaning robot 1000 docks at the station 2000, the cleaning robot 1000 according to an embodiment of the disclosure may detect contact between the first charging terminal 1010 of the cleaning robot 1000 and the second charging terminal 2010 of the station 2000 through the first voltage detection circuit 1100.

The cleaning robot 1000 according to an embodiment of the disclosure may dock at the station 2000 according to a user command to stop cleaning and return to the station 2000 or a remaining battery level. For example, the cleaning robot 1000 may detect an infrared signal emitted from the station 2000 (e.g., a first infrared signal emitted from a left infrared module, a second infrared signal emitted from a central infrared module, and a third infrared signal emitted from a right infrared module) and may perform a docking operation while being aligned with the station 2000. The docking operation may mean that the cleaning robot 1000 is electrically coupled to the station 2000. For example, the docking operation may refer to an operation in which the cleaning robot 1000 causes the first charging terminal 1010 of the cleaning robot 1000 to contact the second charging terminal 2010 of the station 2000 to charge the battery 1050. A user may also manually dock the cleaning robot 1000 at the station 2000.

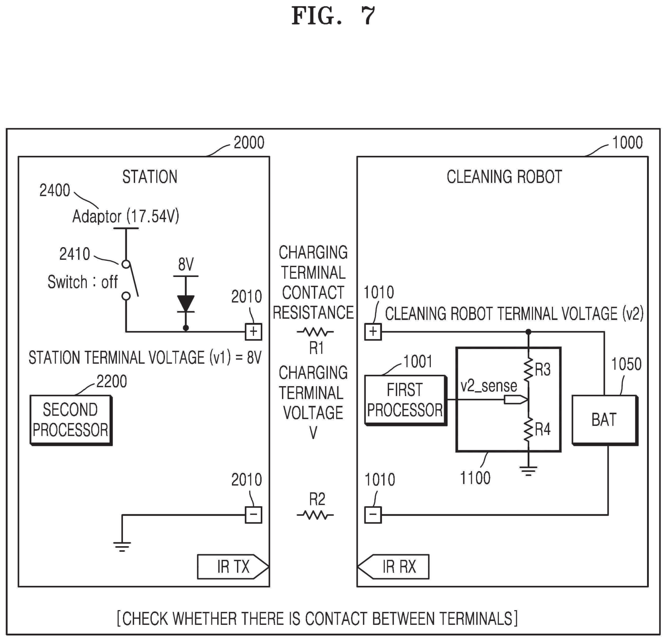

According to an embodiment of the disclosure, when a voltage value detected through the first voltage detection circuit 1100 is equal to or greater than a first threshold voltage value after the docking operation, the cleaning robot 1000 may determine that the first charging terminal 1010 of the cleaning robot 1000 and the second charging terminal 2010 of the station 2000 contact each other. The first threshold voltage value is a preset voltage value and may be a magnitude of a voltage supplied from the station 2000 through the second charging terminal 2010 before a charge command is transmitted to the station 2000. The first threshold voltage value may be, but is not limited to, 8 V. An operation in which the cleaning robot 1000 detects contact between charging terminals will be described in more detail with reference to FIG. 7.

FIG. 7 is a circuit diagram used by the cleaning robot 1000 according to an embodiment of the disclosure to detect contact between the first charging terminal 1010 and the second charging terminal 2010.

Referring to FIG. 7, when the first charging terminal 1010 and the second charging terminal 2010 contact each other, a preset voltage (e.g., 8 V) may be applied from the station 2000 to the cleaning robot 1000. That is, because the second switch 2410 between the power conversion device 2400 (e.g., adaptor) and the second charging terminal 2010 is turned off, 8 V, instead of a voltage (e.g., 17.54 V) output from the power conversion device 2400, may be supplied to the cleaning robot 1000 through the second charging terminal 2010 and the first charging terminal 1010. When the preset voltage (e.g., 8 V) is detected through the first voltage detection circuit 1100, the processor 1001 of the cleaning robot 1000 may determine that the first charging terminal 1010 and the second charging terminal 2010 contact each other.

Referring back to FIG. 6, in operation S620, the cleaning robot 1000 according to an embodiment of the disclosure may transmit a charge command as the contact between the first charging terminal 1010 and the second charging terminal 2010 is detected. For example, the cleaning robot 1000 may transmit a charge command to the station 2000 through the first communication interface 1080 to start a charging sequence.

The charge command may be a command to supply a voltage output from the power conversion device 2400 to charge the battery 1050. Because a voltage (e.g., 17.54 V) output from the power conversion device 2400 is higher than a voltage (e.g., 8 V) preset to detect contact between charging terminals, a charge command may be referred to as a boost command.

According to an embodiment of the disclosure, the cleaning robot 1000 may transmit a charge command through wireless communication or wired communication. For example, the cleaning robot 1000 may transmit a charge command through infrared communication. When the cleaning robot 1000 docks at the station 2000, because an infrared transmission unit and an infrared reception unit may face each other, the cleaning robot 1000 may transmit a charge command through infrared communication. The cleaning robot 1000 may transmit a charge command by using any of various wireless communication methods (e.g., BLE, Wi-Fi direct, UWB, or Zigbee) other than infrared communication. Also, the cleaning robot 1000 may include a communication terminal separate from a charging terminal to transmit a charge command through wired communication.

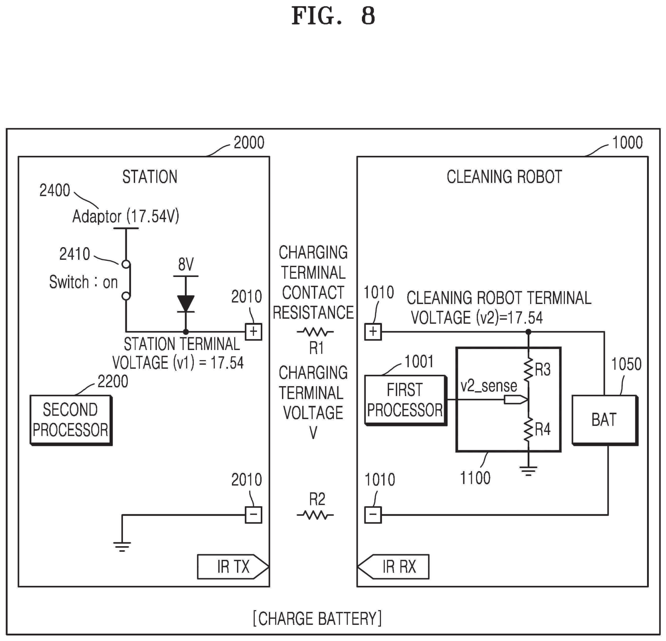

According to an embodiment of the disclosure, when the cleaning robot 1000 transmits a charge command to the station 2000, the station 2000 may turn on the second switch 2410 to supply a voltage output from the power conversion device 2400 to the cleaning robot 1000. In this case, the cleaning robot 1000 may check whether a voltage output from the power conversion device 2400 is supplied to the cleaning robot 1000 by checking a voltage value supplied to the station 2000 through the first voltage detection circuit 1100, which will be described with reference to FIG. 8.

FIG. 8 is a circuit diagram used by the cleaning robot 1000 to check whether boosting occurs, according to an embodiment of the disclosure.

Referring to FIG. 8, when contact between charging terminals is detected, the cleaning robot 1000 may transmit a charge command (boost command) to the station 2000. In this case, the second processor 2200 of the station 2000 may turn on the second switch 2410 according to the charge command (boost command). When the second switch 2410 is turned on, a voltage (e.g., 17.54 V) output from the power conversion device 2400, instead of 8 V, may be supplied to the cleaning robot 1000. The cleaning robot 1000 may detect a voltage value increased from 8 V to 17.54 V through the first voltage detection circuit 1100.

Referring back to FIG. 6, in operation S630, when a voltage is supplied from the station 2000 to the cleaning robot 1000 according to the charge command, the cleaning robot 1000 according to an embodiment of the disclosure may obtain a heating value between the first charging terminal 1010 and the second charging terminal 2010. Hereinafter, a heating value between the first charging terminal 1010 and the second charging terminal 2010 may be referred to as a charging terminal heating value.

For example, when a voltage equal to or greater than a second threshold voltage value (e.g., 17 V) is detected through the first voltage detection circuit 1100, the cleaning robot 1000 may calculate a heating value between the first charging terminal 1010 and the second charging terminal 2010. A heating value between the first charging terminal 1010 and the second charging terminal 2010 may be referred to as a heating value of the first charging terminal 1010 or a heating value of the second charging terminal 2010.

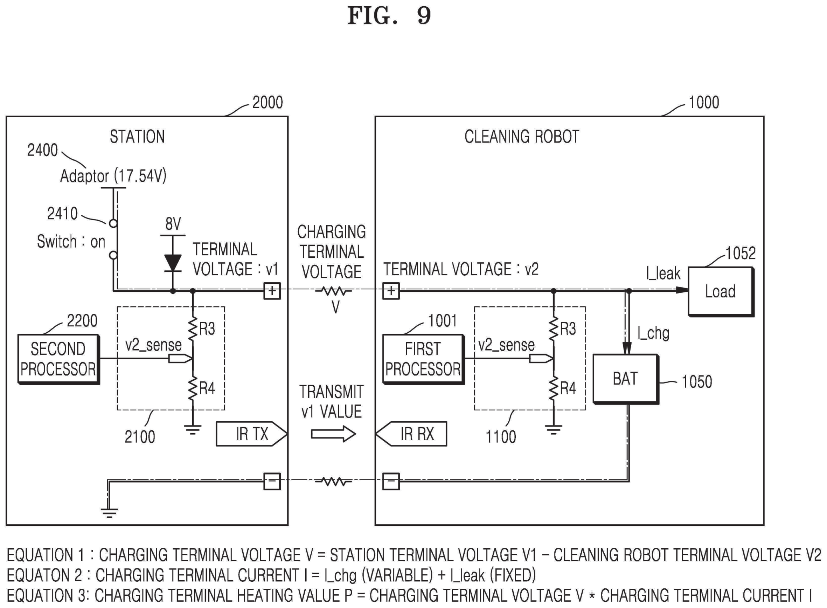

According to an embodiment of the disclosure, the cleaning robot 1000 may calculate a heating value (charging terminal heating value) between the first charging terminal 1010 and the second charging terminal 2010 by using a charging terminal voltage and charging terminal current. A charging terminal voltage may refer to a voltage applied to contact resistance formed between charging terminals in a state where the first charging terminal 1010 and the second charging terminal 2010 contact each other, and may be referred to as a voltage value between the first charging terminal 1010 and the second charging terminal 2010. Charging terminal current may refer to a sum of charge current of the battery 1050 and discharge current of the battery 1050. An operation in which the cleaning robot 1000 calculates a heating value will be described in detail with reference to FIG. 9.

FIG. 9 is a circuit diagram for describing an operation in which a cleaning robot calculates a heating value between a first charging terminal and a second charging terminal, according to an embodiment of the disclosure.

Referring to FIG. 9, the cleaning robot 1000 may obtain a charging terminal heating value P by using Equations 1 to 3. That is, the first processor 1001 of the cleaning robot 1000 may obtain a heating value between the first charging terminal 1010 and the second charging terminal 2010 based on a voltage value v2 of the first charging terminal 1010, a voltage value v1 of the second charging terminal 2010, a discharge current value I_leak of the battery 1050, and a charge current value I_chg of the battery 1050.

charging terminal voltage V = second charging terminal voltage v1 - first charging terminal voltage v2      Equation 1:

$$\text{Equation 2: charging terminal current } I = I\_chg \text{ (variable)} + I\_leak \text{ (fixed)}$$

charging terminal heating value P = charging terminal voltage V * charging terminal current I      Equation 3:

According to an embodiment of the disclosure, to detect a charging terminal voltage V of Equation 1, the cleaning robot 1000 may obtain a first voltage value v2 of the first charging terminal 1010 and may receive information about a second voltage value v1 of the second charging terminal 2010 from the station 2000. The cleaning robot 1000 may obtain a difference between the first voltage value v2 of the first charging terminal, 1010 and the second voltage value v1 of the second charging terminal 2010 as the charging terminal voltage V.

For example, referring to FIG. 9, the cleaning robot 1000 may read a v2_sense value input to an input port of the first processor 1001 through the first voltage detection circuit 1100. The station 2000 may read a v1_sense value input to an input port of the second processor 2200 through the second voltage detection circuit 2100. In this case, the second voltage value v1 of the second charging terminal 2010 and the first voltage value v2 of the first charging terminal 1010 may be calculated as follows.

$$v1 = (R1 + R2) * (v1\_sense / R2)$$

$$v2 = (R3 + R4) * (v2\_sense / R4)$$

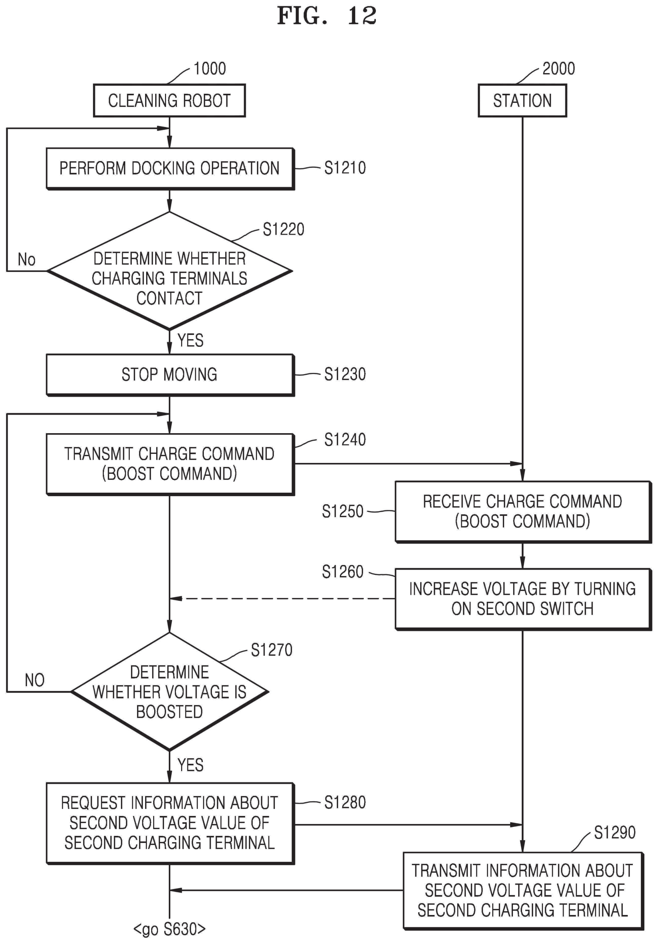

The cleaning robot 1000 may communicate with the station 2000, and the cleaning robot 1000 may read the v1 value or the v1_sense value from a given packet and may calculate the charging terminal voltage V as in Equation 1 (V=v1-v2). An operation in which the cleaning robot 1000 obtains the second voltage value v1 of the second charging terminal 2010 from the station 2000 will be described below in more detail with reference to FIG. 12.

According to an embodiment of the disclosure, the cleaning robot 1000 may obtain a first current value detected through a current detection circuit before charging starts after docking as a discharge current value of the battery 1050. The discharge current value of the battery 1050 may be a fixed value and may be referred to as a leakage current value I_leak. Because current flows from the battery 1050 to a load 1052 before charging starts, a processor (e.g., an MCU) included in a battery management system (BMS) may detect charge current of the battery 1050 through a current detection circuit (e.g., a shunt resistor).

The cleaning robot 1000 may obtain a second current value detected through the current detection circuit after the charging starts as a charge current value of the battery 1050. The charge current value of the battery 1050 may vary according to a state of charge (SoC) of the battery 1050. For example, as a charging amount of the battery 1050 decreases, a charge current value may increase, and as a charging amount of the battery 1050 increases, a charge current value may decrease. This is because the power conversion device 2400 detects a charging amount of the battery 1050 when the cleaning robot 1000 docks at the station 2000 and adjusts charge current according to the charging amount of the battery 1050.

According to an embodiment of the disclosure, when the current detection circuit is located inside the battery 1050, the first processor 1001 of the cleaning robot 1000 may obtain a charge current value I_chg of the battery 1050 and a discharge current value I_leak of the battery 1050 by communicating with the battery controller 1055 (e.g., a battery management system (BMS)) through inter-integrated circuit (I2C) communication. When the first processor 1001 of the cleaning robot 1000 obtains the charge current value of the battery 1050 and the discharge current value of the battery, the processor 1001 of the cleaning robot 1000 may calculate charging terminal current I by using Equation 2 (I=I_chg+I_leak).

According to an embodiment of the disclosure, when the cleaning robot 1000 detects the charging terminal voltage V and the charging terminal current I, the cleaning robot 1000 may calculate a charging terminal heating value P by using Equation 3 (P=V*I). When the cleaning robot 1000 is misaligned with the station 2000 and resistance (contact resistance) formed between charging terminals increases, the charging terminal voltage V increases, and thus, the voltage value v2 of the first charging terminal 1010 measured through the first voltage detection circuit 1100 may decrease and the charging terminal heating value P calculated by the first processor 1001 may increase.

A heating value between the first charging terminal 1010 and the second charging terminal 2010 may vary according to a state of charge of the battery 1050. As a charging rate of the battery 1050 increases, a charge current value may decrease, and thus, the charging terminal heating value P may decrease.

For example, it is assumed that the station 2000 and the cleaning robot 1000 are slightly misaligned with each other, contact resistance of 0.5 ohm is formed between charging terminals, and a charging rate of the battery 1050 is 0%. The cleaning robot 1000 may obtain v1 = 17V, v2 = 15.8V, I_chg = 2A, and I_leak = 0.5A. In this case, the calculated heating value P may be as follows.

$$\text{Heating value } P = (17V\text{-}15.8V)*(2A+0.5A)=3W=3000mW$$

On the other hand, it is assumed that the station 2000 and the cleaning robot 1000 are slightly misaligned with each other, contact resistance of 0.5 ohm is formed between charging terminals, and a charging rate of the battery 1050 is 90%. The cleaning robot 1000 may obtain v1 = 17V, v2 = 16V, I_chg = 0.4A, and I_leak = 0.5A. In this case, the calculated heating value P may be as follows.

$$\text{Heating value } P = (17V\text{-}16V)*(0.4A+0.5A)=0.9W=900mW$$

In operation S640, the cleaning robot 1000 according to an embodiment of the disclosure may determine whether the heating value obtained in operation S630 exceeds a threshold heating value that is a criterion for overheating (hereinafter, referred to as an overheating reference value).

The threshold heating value that is a criterion for overheating (overheating reference value) may be, but is not limited to, a maximum value of a normal heating value. The normal heating value may refer to a heating value generated in a charging terminal when the battery 1050 of the cleaning robot 1000 is charged from 0% to 100% in a normal situation where there is no misalignment of the cleaning robot 1000 or no foreign material between charging terminals. As shown in Equation 1, the charging terminal heating value P may be calculated by multiplying the charging terminal voltage V by the charging terminal current I, and the maximum value of the normal heating value (threshold heating value that is a criterion for overheating) may be calculated as follows.

Maximum value of the normal heating value = I(Adaptor maximum current specification) * V {I(Adaptor maximum current specification) * R(resistance of the first charging terminal [fixed] + resistance of the second charging terminal [fixed] + contact resistance [variable])}

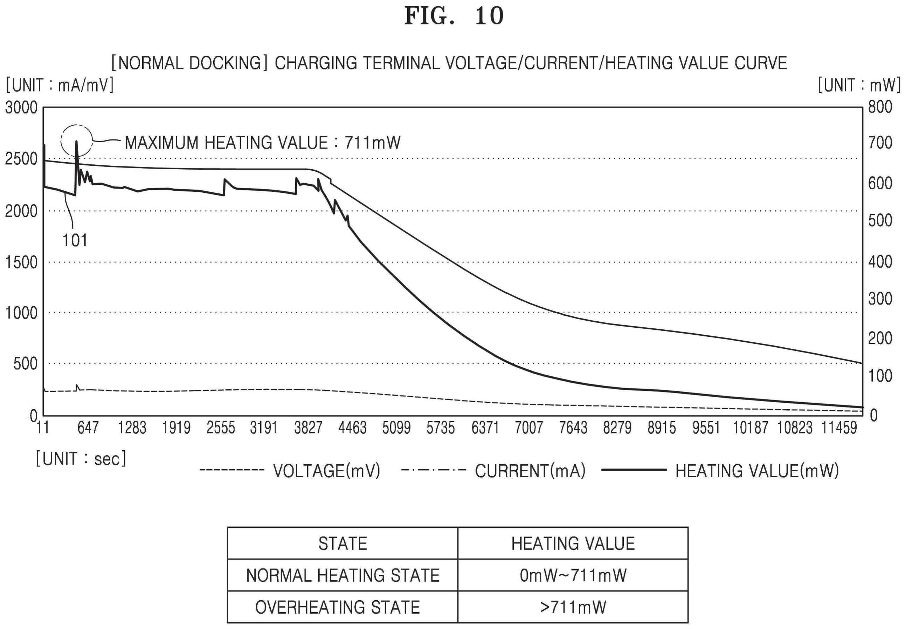

Contact resistance may vary according to a misalignment state between charging terminals or whether there is a foreign material between charging terminals. Because the normal heating value is a heating value generated in a charging terminal in a situation where there is no misalignment of the cleaning robot 1000 (or no foreign material between charging terminals), the contact resistance may be close to 0 Ω when the maximum value of the normal heating value is calculated. A threshold heating value that is a criterion for overheating will be described in more detail with reference to FIG. 10.

FIG. 10 is a diagram for describing a threshold heating value that is a criterion for overheating, according to an embodiment of the disclosure.

In FIG. 10, actual measured values of the charging terminal voltage V, the charging terminal current I, and the charging terminal heating value P during a process of charging the battery 1050 of the cleaning robot 1000 are shown. Referring to a graph 101 of the charging terminal heating value P, because a maximum heating value during a normal charging process is 711 mW, the cleaning robot 1000 may define 0 mW to 711 mW as a normal heating value and may define a heating value higher than 711 mW as an overheating value. That is, a threshold heating value that is a criterion for overheating (overheating reference value) may be, but is not limited to, 711 mW. The threshold heating value that is a criterion for overheating may vary according to a specification of the cleaning robot 1000, a specification of the station 2000, etc. For convenience of explanation, the following will be described assuming that the threshold heating value that is a criterion for overheating is 711 mW.

According to an embodiment of the disclosure, when the cleaning robot 1000 and the station 2000 are misaligned with each other, contact resistance between charging terminals is 0.5 ohm, and a charging rate of the battery 1050 is 0%, v1 = 17V, v2 = 15.8V, I_chg = 2A, and I_leak = 0.5A. In this case, the calculated heating value P may be 3000 mW (= (17V-15.8V)*(2A+0.5A)=3W). Because the calculated heating value (3000 mW) exceeds the overheating reference value (e.g., 711 mW), the cleaning robot 1000 may determine that a charging terminal is in an overheating state.

According to an embodiment of the disclosure, when there is a foreign material between charging terminals, contact resistance between the charging terminals is 0.5 ohm, and a charging rate of the battery 1050 is 90%, v1 = 17V, v2 = 16V, I_chg = 0.4A, and I_leak = 0.5A. In this case, the calculated heating value P may be 900 mW (=(17V-16V)* (0.4A+0.5A)=0.9W). Because the calculated heating value (e.g., 900 mW) exceeds the overheating reference value (e.g., 711 mW), the cleaning robot 1000 may determine that a charging terminal is in an overheating state.

According to an embodiment of the disclosure, when the cleaning robot 1000 and the station 2000 are well aligned with each other, contact resistance between charging terminals is close to 0 ohm, and a charging rate of the battery 1050 is 90%, v1 = 17V, v2 = 16.8V, I_chg = 0.4A, and I_leak = 0.5A. In this case, the calculated heating value P may be 180 mW (=(17V-16.8V)*(0.4A+0.5A)=0.18W). Because the calculated heating value (180 mW) is lower than the overheating reference value (e.g., 711 mW), the cleaning robot 1000 may determine that a charging terminal is in a normal heating state.

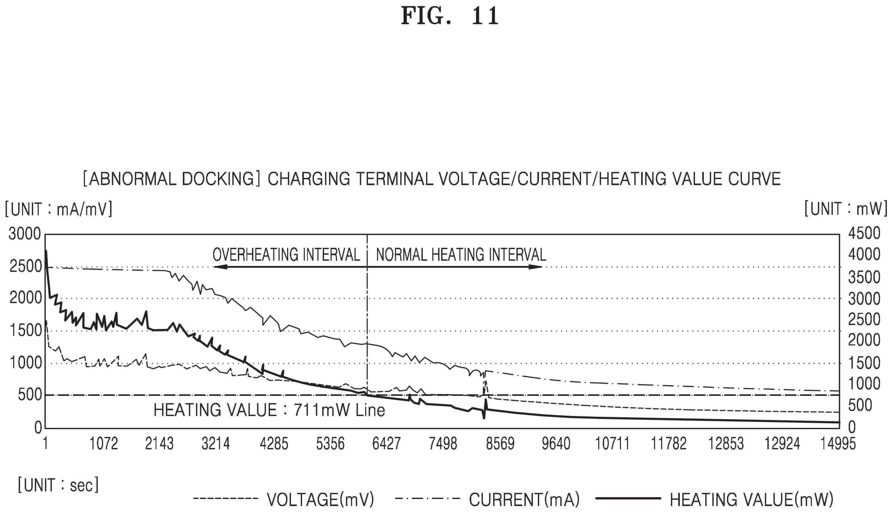

In conclusion, referring to FIG. 11, when a charging terminal heating value exceeds an overheating reference value (e.g., 711 mW), the cleaning robot 1000 may determine that a charging terminal is in an overheating state, and when a charging terminal heating value is lower than the overheating reference value (e.g., 711 mW), the cleaning robot 1000 may determine that a charging terminal is in a normal heating state. As shown in FIG. 11, as a charging rate of the battery 1050 increases, a charging terminal heating value may decrease. Accordingly, when contact resistance between charging terminals is the same but a charging rate of the battery 1050 is high, it may be determined as a normal heating state, and when contact resistance is the same and a charging rate of the battery 1050 is low, it may be determined as an overheating state.

According to an embodiment of the disclosure, when the heating value obtained in operation S630 is equal to or lower than the threshold heating value (No in operation S640), to continuously perform charging, the cleaning robot 1000 may transmit a charge command (boost command) to the station 2000 at a predetermined time interval. For example, the cleaning robot 1000 may transmit a charge command (boost command) to the station 2000 at an interval of 0.8 seconds through wireless communication. Also, the cleaning robot 1000 may continuously monitor whether a charging terminal heating value exceeds an overheating reference value during charging by periodically calculating the charging terminal heating value.

In operation S650, when the heating value obtained in operation S630 exceeds the threshold heating value that is a criterion for overheating (Yes in operation S640), the cleaning robot 1000 may perform a re-docking operation after moving away from the station 2000 by a predetermined distance.

When the cleaning robot 1000 controls the moving assembly 1062 to be separated from the station 2000 by a predetermined distance, the contact between the first charging terminal 1010 and the second charging terminal 2010 may be removed and power supply from the station 2000 to the cleaning robot 1000 may be stopped, thereby releasing an overheating state. Accordingly, the cleaning robot 1000 may prevent damage to a component or a fire from occurring due to overheating.

When the overheating state is released, the cleaning robot 1000 may dock while being aligned with the station 2000 to charge the battery 1050 again. For example, when the cleaning robot 1000 is separated from the station 2000 by a predetermined distance, wireless communication connection (e.g., infrared communication connection) between the cleaning robot 1000 and the station 2000 may be interrupted. When the wireless communication connection between the station 2000 and the cleaning robot 1000 is interrupted, the station 2000 may emit an infrared signal for docking of the cleaning robot 1000. For example, the station 2000 may control each of a left infrared module, a central infrared module, and a right infrared module to emit an infrared signal. The cleaning robot 1000 may detect each of a first infrared signal emitted from the left infrared module, a second infrared signal emitted from the central infrared module, and a third infrared signal emitted form the right infrared module. The cleaning robot 1000 may dock at the station 2000 while being aligned with the station 2000 by using an angle of incidence of each of the first infrared signal, the second infrared signal, and the third infrared signal.

According to an embodiment of the disclosure, the cleaning robot 1000 may return to operation S610 after performing the re-docking operation. That is, as the re-docking operation is performed, the cleaning robot 1000 may detect contact between the first charging terminal 1010 and the second charging terminal 2010 and may transmit a charge command (boost command) to the station 2000. When power is supplied from the station 2000 to the cleaning robot 1000 according to the charge command (boost command), the cleaning robot 1000 may calculate a heating value between the first charging terminal 1010 and the second charging terminal 2010, and, when the calculated heating value exceeds a threshold heating value, because a charging terminal is in an overheating state, the cleaning robot 1000 may perform a docking operation again. That is, according to an embodiment of the disclosure, when the cleaning robot 1000 is not aligned with the station 2000, the cleaning robot 1000 may perform re-docking several times. When the calculated heating value after the re-docking does not exceed the threshold heating value, because a charging terminal is in a normal heating state, the cleaning robot 1000 may charge the battery 1050 by periodically transmitting a charge command (boost command) to the station 2000.

An operation in which the cleaning robot 1000 transmits a charge command (boost command) to the station 2000 and a reply command to a second voltage value of the second charging terminal 2010 will be described in more detail with reference to FIG. 12.

FIG. 12 is a flowchart for describing a method by which the cleaning robot 1000 transmits a charge command to the station 2000, according to an embodiment of the disclosure.

In operation S1210, the cleaning robot 1000 according to an embodiment of the disclosure may perform a docking operation. For example, when the battery 1050 needs to be charged or a docking command is received from a user, the cleaning robot 1000 may perform a docking operation.

According to an embodiment of the disclosure, the cleaning robot 1000 may detect at least one infrared signal emitted from the station 2000 and may dock while being aligned with the station 2000. For example, the cleaning robot 1000 may perform a docking operation while being aligned with the station 2000, by using an angle of incidence of each of a first infrared signal emitted from a right infrared module, a second infrared signal emitted from a central infrared module, and a third infrared signal emitted from a left infrared module.

The user may lift the cleaning robot 1000 from a floor and may manually dock the cleaning robot 1000 at the station 2000.

In operation S1220, when the cleaning robot 1000 docks at the station 2000, the cleaning robot 1000 according to an embodiment of the disclosure may detect contact between charging terminals. For example, when a voltage value detected through the first voltage detection circuit 1100 is equal to or greater than a first threshold voltage value (e.g., 8 V, see FIG. 7), the cleaning robot 1000 may determine that the first charging terminal 1010 of the cleaning robot 1000 and the second charging terminal 2010 of the station 2000 contact each other. Operation S1220 corresponds to operation S610 of FIG. 6, and thus, a detailed description thereof will be omitted.

According to an embodiment of the disclosure, when contact between charging terminals is not detected during charging, the cleaning robot 1000 may move while adjusting a location of the cleaning robot 1000 so that the first charging terminal 1010 contacts the second charging terminal 2010.

In operation S1230, when the contact between the charging terminals is detected, the cleaning robot 1000 according to an embodiment of the disclosure may stop moving. For example, when the first charging terminal 1010 contacts the second charging terminal 2010, the cleaning robot 1000 may determine that docking at the station 2000 has been normally completed and may stop moving.

In operation S1240, when docking at the station 2000 is completed, the cleaning robot 1000 according to an embodiment of the disclosure may transmit a charge command (boost command) to the station 2000.

According to an embodiment of the disclosure, when the contact between the first charging terminal 1010 and the second charging terminal 2010 is detected, the cleaning robot 1000 may transmit a charge command (boost command) to the station 2000 through wired communication or wired communication. For example, the cleaning robot 1000 may transmit a charge command through infrared communication.

Operation S1240 corresponds to operation S620 of FIG. 6, and thus, a detailed description thereof will be omitted.

In operation S1250, the station 2000 according to an embodiment of the disclosure may receive the charge command (boost command) from the cleaning robot 1000. For example, the station 2000 may receive the charge command (boost command) from the cleaning robot 1000 through the second communication interface 2300. When the cleaning robot 1000 docks, the station 2000 may periodically receive the charge command (boost command) from the cleaning robot 1000. The station 2000 may check a communication connection state with the cleaning robot 1000 through the periodically received charge command.

In operation S1260, the station 2000 according to an embodiment of the disclosure may increase a voltage supplied to the cleaning robot 1000 by turning on the second switch 2410 (see FIG. 8). For example, the station 2000 may supply a voltage supplied from the power conversion device 2400 to the cleaning robot 1000 by turning on the second switch 2410. When the second switch 2410 is turned on, a voltage output form the power conversion device 2400, instead of a voltage of a certain magnitude (e.g., 8 V) for detecting contact between charging terminals, may be supplied to the cleaning robot 1000.

In operation S1270, the cleaning robot 1000 according to an embodiment of the disclosure may check whether a voltage supplied from the station 2000 is boosted.

According to an embodiment of the disclosure, the cleaning robot 1000 may detect a supply voltage of the station 2000 through the first voltage detection circuit 1100. Because the first switch 1111 (see FIG. 4) of the cleaning robot 1000 is turned off state before checking whether a voltage is boosted, the cleaning robot 1000 may detect a voltage supplied from the station 2000 through the first voltage detection circuit 1100, regardless of whether misalignment occurs. For example, when the station 2000 turns on the second switch 2410, the cleaning robot 1000 may detect a voltage value increased from 8 V to 17.54 V through the first voltage detection circuit 1100.

According to an embodiment of the disclosure, when a voltage supplied from the station 2000 is not boosted (No in operation S1270), the cleaning robot 1000 may transmit a charge command (boost command) to the station 2000 again.

According to an embodiment of the disclosure, when a voltage supplied from the station 2000 is boosted, the cleaning robot 1000 may turn on the first switch 1111 to allow current to flow through the cleaning robot 1000. To calculate a charging terminal heating value, the cleaning robot 1000 may detect a first voltage value of the first charging terminal 1010 through the first voltage detection circuit 1100.

In operation S1280, when a voltage supplied from the station 2000 is boosted (Yes in operation S1270), the cleaning robot 1000 according to an embodiment of the disclosure may request the station 2000 for a second voltage value of the second charging terminal 2010. For example, when a voltage supplied from the station 2000 is boosted, the cleaning robot 1000 may command the station 2000 to send a reply to the second voltage value of the second charging terminal 2010 in order to calculate a charging terminal heating value.

According to an embodiment of the disclosure, the cleaning robot 1000 may request the station 2000 for the second voltage value of the second charging terminal 2010 through wireless communication or wired communication. For example, the cleaning robot 1000 may request the station 2000 for information about the second voltage value of the second charging terminal 2010 through infrared communication.

In operation S1290, the station 2000 according to an embodiment of the disclosure may transmit the information about the second voltage value of the second charging terminal 2010 in response to a request (reply command) received from the cleaning robot 1000.

According to an embodiment of the disclosure, the station 2000 may detect the second voltage value of the second charging terminal 2010 through the second voltage detection circuit 2100. For example, referring to FIG. 9, the station 2000 may read a v1_sense value input to an input port of the second processor 2200 through the second voltage detection circuit 2100. In this case, a second voltage value v1 of the second charging terminal 2010 may be calculated as follows.

$$v1 = (R1 + R2) * (v1\_sense / R2)$$

The station 2000 may transmit the information (e.g., the v1 value or the v1_sense value) about the second voltage value of the second charging terminal 2010 through wireless communication or wired communication.

According to an embodiment of the disclosure, when the information about the second voltage value of the second charging terminal 2010 is received from the station 2000, the cleaning robot 1000 may calculate a charging terminal heating value (see operation S630 of FIG. 6). For example, the first processor 1001 of the cleaning robot 1000 may detect a first voltage value v2 of the first charging terminal 1010, may obtain a charge current value I_chg of the battery 1050 and a discharge current value I_leak of the battery 1050 from the battery 1050, may receive the second voltage value v1 of the second charging terminal 2010 from the station 2000, and may calculate a heating value by using the following equation.

Charging terminal heating value P = charging terminal voltage V * charging terminal current I

$$\text{Charging terminal heating value P} = \text{charging terminal voltage V} * \text{charging terminal current I}$$

$$= [v1 - v2] * [I\_chg + I\_leak]$$

According to an embodiment of the disclosure, the cleaning robot 1000 may request and receive the information about the second voltage value of the second charging terminal 2010 from the station 2000 at a predetermined time interval (e.g., an interval of 1.6 seconds) and may calculate a charging terminal heating value at a predetermined time interval (e.g., an interval of 1.6 seconds).

When the calculated heating value exceeds an overheating reference value, the cleaning robot 1000 may perform a re-docking operation after moving away from the station 2000 by a predetermined distance, thereby preventing damage to a component or a fire from occurring due to overheating.

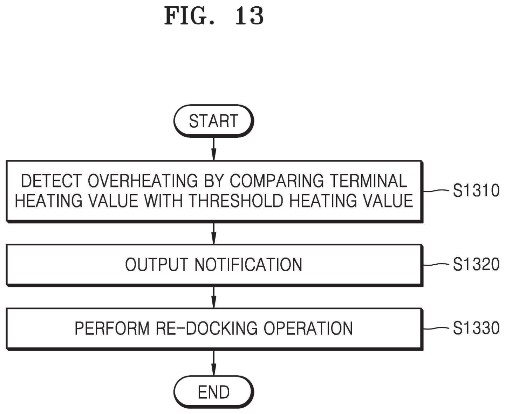

When the calculated heating value exceeds the overheating reference value, the cleaning robot 1000 may output a notification through the first output interface 1073. Hereinafter, a method by which the cleaning robot 1000 outputs a notification will be described in detail with reference to FIG. 13.

FIG. 13 is a flowchart for describing a method by which a cleaning robot 1000 outputs a notification, according to an embodiment of the disclosure.

In operation S1310, the cleaning robot 1000 according to an embodiment of the disclosure may detect overheating of a charging terminal by comparing a charging terminal heating value with a threshold heating value that is a criterion for overheating (overheating reference value). For example, when the charging terminal heating value exceeds the overheating reference value, the cleaning robot 1000 may determine that a charging terminal is in an overheating state.

Operation S1310 corresponds to operation S640 of FIG. 6, and thus, a repeated description will be omitted.

In operation S1320, when the cleaning robot 1000 according to an embodiment of the disclosure detects overheating, the cleaning robot 1000 may output a notification through the first output interface 1073. For example, the cleaning robot 1000 may output a notification message as a voice through a speaker.

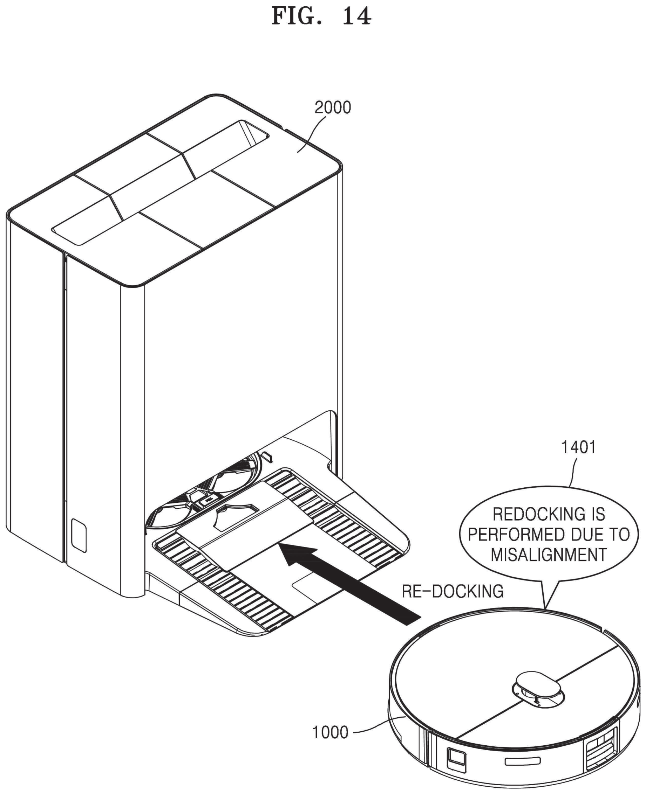

Referring to FIG. 14, when the charging terminal heating value exceeds the overheating reference value, the cleaning robot 1000 may output a voice message 1401 indicating that re-docking is performed due to misalignment through the speaker. Also, the cleaning robot 1000 may output a preset music sound to notify re-docking. Although not shown in FIG. 14, according to an embodiment of the disclosure, when the cleaning robot 1000 includes a display, the cleaning robot 1000 may display a notification message indicating that re-docking is performed due to misalignment on the display. A user may check a reason why the cleaning robot 1000 performs re-docking through the notification output from the cleaning robot 1000.

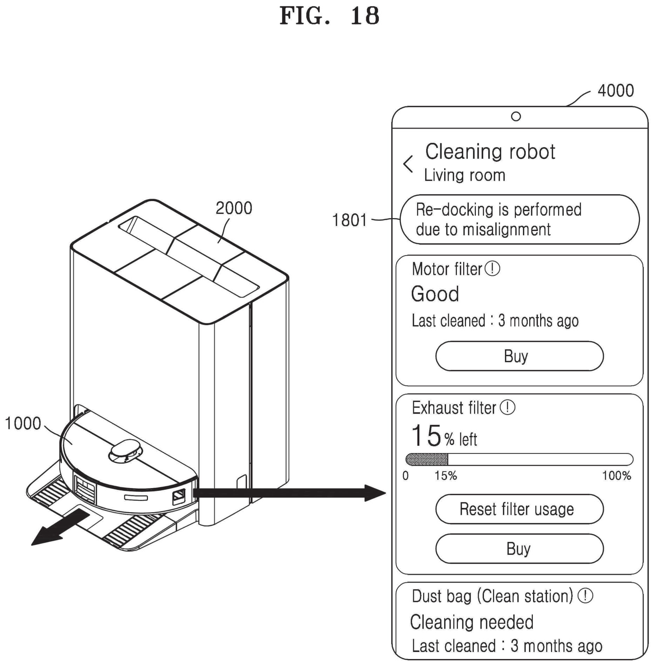

The cleaning robot 1000 may output a notification through a user terminal connected to a server. An operation in which the cleaning robot 1000 outputs a notification through the user terminal will be described below in detail with reference to FIG. 18.

In operation S1330, when the overheating of the charging terminal is detected, the cleaning robot 1000 according to an embodiment of the disclosure may perform re-docking after outputting the notification.

According to an embodiment of the disclosure, the cleaning robot 1000 may perform a re-docking operation after moving away from the station 2000 by a predetermined distance. When the cleaning robot 1000 controls the moving assembly 1062 to move away from the station 2000 by a predetermined distance, because contact between the first charging terminal 1010 and the second charging terminal 2010 may be removed and power supply from the station 2000 to the cleaning robot 1000 may be stopped, thereby releasing an overheating state. Accordingly, the cleaning robot 1000 may prevent damage to a component or a fire from occurring due to overheating.

Operation S1330 corresponds to operation S650 of FIG. 6, and thus, a repeated description will be omitted.

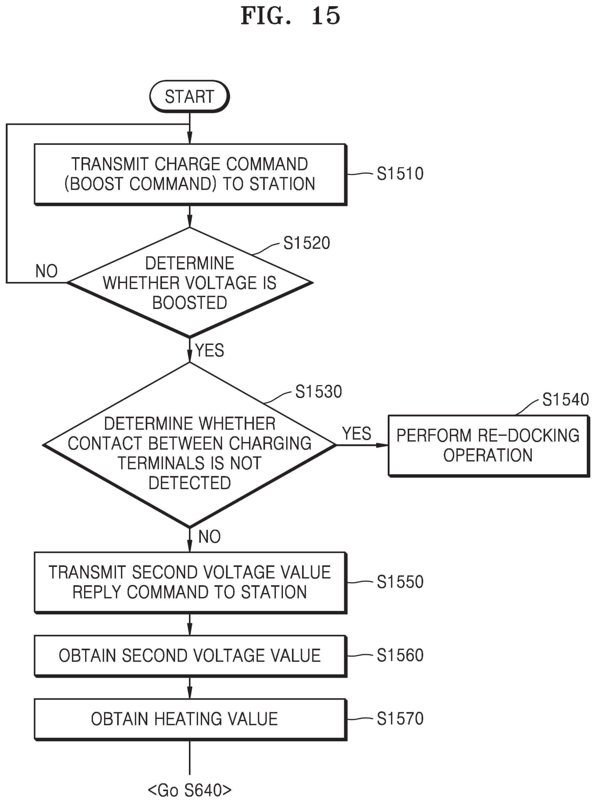

According to an embodiment of the disclosure, the cleaning robot 1000 may perform re-docking even when contact between charging terminals is not detected in addition to when overheating is detected in a state where the cleaning robot 1000 docks at the station 2000. A method by which the cleaning robot 1000 performs re-docking when contact between charging terminals is not detected will be described in detail with reference to FIG. 15.

FIG. 15 is a flowchart for describing a method by which the cleaning robot 1000 performs a re-docking operation, according to an embodiment of the disclosure.

In operation S1510, the cleaning robot 1000 according to an embodiment of the disclosure may transmit a charge command (boost command) to the station 2000. For example, when contact between the first charging terminal 1010 and the second charging terminal 2010 is detected, the cleaning robot 1000 may transmit a charge command (boost command) to the station 2000 through wireless communication (e.g., infrared communication).

In operation S1520, the cleaning robot 1000 according to an embodiment of the disclosure may detect whether a voltage is boosted through the first voltage detection circuit 1100.

According to an embodiment of the disclosure, when the charge command (boost command) is received from the cleaning robot 1000, the station 2000 may turn on the second switch 2410 to supply a voltage (e.g., 17.54 V) output from the power conversion device 2400 to the cleaning robot 1000. In this case, the cleaning robot 1000 may detect a supply voltage of the station 2000 increased from 8 V to 17.54 V through the first voltage detection circuit 1100.

When a voltage supplied from the station 2000 is not boosted (No in operation S1520), the cleaning robot 1000 may transmit a charge command (boost command) to the station 2000 again.

In operation S1530, the cleaning robot 1000 according to an embodiment of the disclosure may detect that contact between charging terminals is removed after checking that a voltage is boosted.

According to an embodiment of the disclosure, when it is checked that a supply voltage of the station 2000 is boosted but the cleaning robot 1000 and the station 2000 are misaligned with each other due to external impact, the cleaning robot 1000 may no longer detect contact between the first charging terminal 1010 and the second charging terminal 2010. That is, when a supply voltage of the station 2000 is no longer detected through the first voltage detection circuit 1100, the cleaning robot 1000 may identify that the contact between the charging terminals is removed.

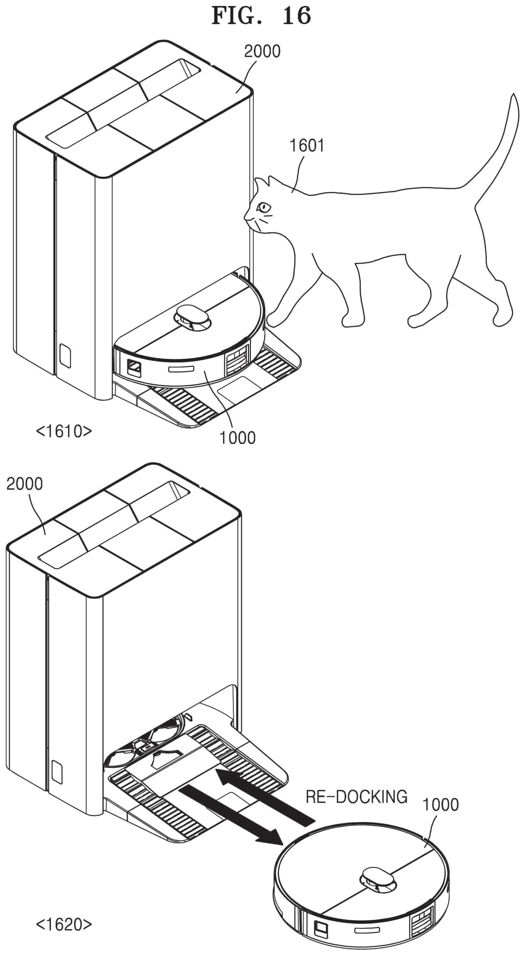

In operation S1540, when the contact between the charging terminals is not detected (Yes in operation S1530), the cleaning robot 1000 according to an embodiment of the disclosure may perform a re-docking operation, which will be described with reference to FIG. 16.

FIG. 16 is a view for describing a re-docking operation of the cleaning robot 1000, according to an embodiment of the disclosure.

Referring to 1610 of FIG. 16, in a state where the cleaning robot 1000 normally docks at the station 2000, a pet 1601 may apply impact to the station 2000 or the cleaning robot 1000. Contact between the second charging terminal 2010 of the station 2000 and the first charging terminal 1010 of the cleaning robot 1000 may be lost by the impact of the pet 1601. In this case, because a supply voltage of the station 2000 may no longer be detected through the first voltage detection circuit 1100, the cleaning robot 1000 may identify that the contact between the first charging terminal 1010 and the second charging terminal 2010 is lost.

Referring to operation 1620 of FIG. 16, when it is identified that the contact between the first charging terminal 1010 and the second charging terminal 2010 is lost, the cleaning robot 1000 may perform a re-docking operation to charge the battery 1050. For example, the cleaning robot 1000 may move away from the station 2000 by a predetermined distance and then may perform a re-docking by detecting infrared signals emitted from the station 2000. When the cleaning robot 1000 succeeds in re-docking at the station 2000, the cleaning robot 1000 may detect contact between the first charging terminal 1010 and the second charging terminal 2010 through the first voltage detection circuit 1100.

Referring back to FIG. 15, in operation S1550, when the contact between the charging terminals is well maintained (No in operation S1530), the cleaning robot 1000 according to an embodiment of the disclosure may transmit a second voltage value reply command of the second charging terminal 2010 to the station 2000. For example, the cleaning robot 1000 may transmit a second voltage value reply command to the station 2000 through wireless communication (e.g., infrared communication) at a certain interval (e.g., 1.6 seconds).

In operation S1560, the cleaning robot 1000 according to an embodiment of the disclosure may obtain a second voltage value from the station 2000. For example, when the station 2000 provides information about the second voltage value to the cleaning robot 1000 in response to the second voltage value reply command, the cleaning robot 1000 may receive the information about the second voltage value from the station 2000. The station 2000 may detect the second voltage value of the second charging terminal 2010 through the second voltage detection circuit 2100.

According to an embodiment of the disclosure, the cleaning robot 1000 may receive the second voltage value of the second charging terminal 2010 from the station 2000 through wireless communication (e.g., infrared communication) at a certain interval (e.g., 1.6 seconds).

In operation S1570, when the second voltage value of the second charging terminal 2010 is received, the cleaning robot 1000 may obtain a charging terminal heating value.

For example, the first processor 1001 of the cleaning robot 1000 may detect a first voltage value v2 of the first charging terminal 1010, may obtain a charge current value I_chg of the battery 1050 and a discharge current value I_leak of the battery 1050 from the battery 1050, may receive a second voltage value v1 of the second charging terminal 2010 from the station 2000, and may calculate a charging terminal heating value by using the following equation.

EP 4 728 949 A1

$$\text{Charging terminal heating value } P = \text{charging terminal voltage } V * \text{charging terminal current } I$$

$$= [v1 - v2] * [I\_chg + I\_leak]$$

Operations S1530 and 1540 may be performed after operation S1550, after operation S1560, or after operation S1570. That is, when it is detected that contact between the first charging terminal 1010 and the second charging terminal 2010 is removed at any time during charging of the battery 1050, the cleaning robot 1000 may perform a re-docking operation so that the first charging terminal 1010 contacts the second charging terminal 2010 again.

FIG. 17 is a view for describing an operation in which the cleaning robot 1000 interoperates with a server 3000, according to an embodiment of the disclosure.

Referring to FIG. 17, a cleaning system according to an embodiment of the disclosure may include the server 3000 and a user terminal 4000 in addition to the cleaning robot 1000 and the station 2000. The cleaning robot 1000 and the station 2000 have been described with reference to FIG. 1, and thus, the server 3000 and the user terminal 4000 will now be described.

The server 3000 according to an embodiment of the disclosure may be a device for managing the cleaning robot 1000. For example, the server 3000 may be a home appliance management server. The server 3000 may manage user account information and information about a home appliance connected to a user account. For example, a user may create a user account by accessing the server 3000 through the user terminal 4000. The user account may be identified by an ID and a password set by the user. The server 3000 may register the station 2000 or the cleaning robot 1000 in the user account according to a pre-determined procedure. For example, the server 3000 may register the station 2000 and the cleaning robot 1000 by linking identification information (e.g., a serial number or a MAC address) of the station 2000 or identification information of the cleaning robot 1000 to the user account. When the station 2000 or the cleaning robot 1000 is registered in the server 3000, the server 3000 may manage a state of the station 2000 or a state of the cleaning robot 1000 by periodically receiving state information of the station 2000 or station information of the cleaning robot 1000 from the station 2000 or the cleaning robot 1000.

The server 3000 may include a communication module capable of communicating with another server, the cleaning robot 1000, an external device, or the user terminal 4000, at least one processor capable of processing data received from another server, the cleaning robot 1000, an external device, or the user terminal 4000, and at least one memory capable of storing a program for processing data or processed data. The server 3000 may be implemented as any of various computing devices such as a workstation, a cloud, a data drive, or a data station. The server 3000 may be implemented as one or more servers that are physically or logically divided based on functions, detailed configurations of functions, or data, and may transmit and receive data through communication between servers and may process the transmitted and received data.

The server 3000 may receive information about an operation or a state of the cleaning robot 1000 or receive information about a user of the user terminal 4000, may process the received information by using technology such as artificial intelligence, and may transmit a processing result or a control command to the cleaning robot 1000 based on the processing result.

The user terminal 4000 may be a device registered in the server 3000 under the same account as the station 2000 or the cleaning robot 1000. The user terminal 4000 may be carried by the user or placed in the user's home or office. Examples of the user terminal 4000 may include, but are not limited to, a smartphone, a laptop computer, a tablet PC, a digital camera, an e-book terminal, a digital broadcasting terminal, a personal digital assistant (PDA), a portable multimedia player (PMP), a wearable device, and a device including a display. For convenience of explanation, the following will be described assuming that the user terminal 4000 is a smartphone.

According to an embodiment of the disclosure, the user terminal 4000 may communicate with at least one of the server 3000, the cleaning robot 1000, or the station 2000. The user terminal 4000 may directly communicate with the cleaning robot 1000 or the station 2000 through short-range wireless communication, or may indirectly communicate with the cleaning robot 1000 or the station 2000 through the server 3000.

The user terminal 4000 may include a communication module capable of communicating with an external device, a user interface through which a user input is received or information is output to the user, at least one processor for controlling an operation of the user terminal 4000, and at least one memory in which a program for controlling an operation of the user terminal 4000 is stored.

A program, that is, an application, for controlling a home appliance (e.g., the cleaning robot 1000) may be stored in the at least one memory of the user terminal 4000. The application may be sold while being installed on the user terminal 4000 or may be downloaded and installed from an external server.

The user may generate a user account by accessing the server 3000 by executing the application installed on the user terminal 4000 and may register the cleaning robot 1000 or the station 2000 by communicating with the server 3000

19

based on the logged-in user account. For example, when the cleaning robot 1000 is manipulated so that the cleaning robot 1000 accesses the server 3000 according to a procedure guided by the application installed on the user terminal 4000, the server 3000 may register the cleaning robot 1000 in the user account by registering identification information (e.g., serial number of MAC address) of the cleaning robot 1000 in the user account.

The user may control the cleaning robot 1000 or the station 2000 by using the application installed on the user terminal 4000. For example, when the user logs into the user application with the application installed on the user terminal 4000, the cleaning robot 1000 registered in the user account may be shown, and when the user inputs a control command to the cleaning robot 1000, the control command may be transmitted to the cleaning robot 1000 through the server 3000. The cleaning robot 1000 may operate according to the control command received from the user terminal 4000 or the server 3000. For example, when the cleaning robot 1000 obtains the user's prior approval so that the cleaning robot 1000 operates according to a control command of the server 3000 even without a user input, the cleaning robot 1000 may operate according to the control command received from the server 3000. The control command received from the server 3000 may include, but is not limited to, a control command input by the user through the user terminal 4000 or a control command based on a preset condition.

According to an embodiment of the disclosure, the user terminal 4000 may execute a specific application (e.g., a home appliance management application) provided by the server 3000 based on a user input. In this case, the user terminal 4000 may provide information about a state of the cleaning robot 1000 or a state of the station 2000 through an execution window of the application. Also, the user terminal 4000 may output a notification related to the cleaning robot 1000 on the execution window of the application. An operation in which the user terminal 4000 outputs a notification related to the cleaning robot 1000 will be described in more detail with reference to FIG. 18.

FIG. 18 is a view for describing an operation in which the cleaning robot 1000 outputs a notification through the user terminal 4000, according to an embodiment of the disclosure.

According to an embodiment of the disclosure, the cleaning robot 1000 may detect overheating by comparing a charging terminal heating value with a threshold heating value that is a criterion for overheating (overheating reference value). For example, when the charging terminal heating value exceeds the overheating reference value, the cleaning robot 1000 may determine that a charging terminal is in an overheating state.

When the overheating is detected, the cleaning robot 1000 may output a notification indicating that re-docking is performed through the user terminal 4000 before performing re-docking. For example, the cleaning robot 1000 may transmit, to the user terminal 4000, information indicating that re-docking is performed due to misalignment with the station 2000. The cleaning robot 1000 may transmit the information indicating that re-docking is performed to the user terminal 4000 through the server 3000 or may directly transmit to the user terminal 4000 through wireless communication.

When the cleaning robot 1000 receives the information indicating that re-docking is performed due to misalignment with the station 2000, the user terminal 4000 may display a notification message indicating that the cleaning robot 1000 performs re-docking on an execution window of an application for managing a home appliance. For example, the user terminal 4000 may output a notification message 1801 saying that "Re-docking is performed due to misalignment". A user may check a reason why the cleaning robot 1000 performs re-docking through the notification message displayed on the execution window of the application.

FIG. 19 is a view for describing a cleaning system including a cordless stick cleaner 1000-1, which may generally be referred to as a cordless vacuum cleaner, according to an embodiment of the disclosure.

The cleaning system according to an embodiment of the disclosure may include the cordless stick cleaner 1000-1, instead of the cleaning robot 1000. Accordingly, the cleaning system according to an embodiment of the disclosure may include the cordless stick cleaner 1000-1 and a station 2000-1. Also, the cleaning system may include the server 3000 or the user terminal 4000 in addition to the cordless stick cleaner 1000-1 and the station 2000-1.

The cordless stick cleaner 1000-1 may include the rechargeable battery 1050 therein and may be a vacuum cleaner that does not need to connect a power cord to an outlet during cleaning. A user may allow a brush device (cleaner head) to suck up foreign materials (e.g., dust, hair, and trash) from a surface to be cleaned while moving the cordless stick cleaner 1000-1 back and forth by using a handle mounted on a cleaner body. The foreign materials sucked up from the surface to be cleaned through the brush device may be collected in a dust bin of the cleaner body. The cordless stick cleaner 1000-1 may include a suction motor configured to form a vacuum in the cordless stick cleaner 1000-1. Hereinafter, for convenience of explanation, the suction motor of the cordless stick cleaner 1000-1 is referred to as a first suction motor. The cordless stick cleaner 1000-1 may include a communication interface for performing communication with the station 2000-1. For example, the cordless stick cleaner 1000-1 may transmit and receive data to and from the station 2000-1 through a wireless personal area network (WPAN) (e.g., BLE).

The station 2000-1 may be a device for discharging dust, charging a battery, or storing the cordless stick cleaner 1000-1. According to an embodiment of the disclosure, the station 2000-1 may communicate with the cordless stick cleaner 1000-1 or the server 3000 through a network. For example, the station 2000-1 may transmit and receive data to and from the cordless stick cleaner 1000-1 through a short-range wireless network (wireless personal area network (WPAN)) without an access point (AP). The station 2000 may transmit and receive data to and from the server 3000 through an AP that connects a local area network (LAN) to which the station 2000-1 is connected to a wide area network (WAN) to which the server 3000 is connected. For example, the station 2000-1 may be connected to the cordless stick cleaner 1000-1 through Bluetooth low energy (BLE) communication, and may be connected to the server 3000 through Wi-FiTM (IEEE 802.11) communication, but an embodiment of the disclosure is not limited thereto.

Referring to 1910 of FIG. 19, the user may use the cordless stick cleaner 1000-1 and then may mount (dock) the cordless stick cleaner 1000-1 at the station 2000-1. As a distance between the cordless stick cleaner 1000-1 and the station 2000-1 decreases, the cordless stick cleaner 1000-1 and the station 2000-1 may establish a short range wireless communication channel and may transmit and receive data. When the cordless stick cleaner 1000-1 is mounted on the station 2000-1, the cordless stick cleaner 1000-1 and the station 2000-1 may be electrically coupled to each other through a charging terminal. For example, the first charging terminal 1010 of the cordless stick cleaner 1000-1 and the second charging terminal 2010 of the station 2000-1 may contact each other.

Referring to 1920 of FIG. 19, although the cordless stick cleaner 1000-1 docks at the station 2000-1 and the first charging terminal 1010 and the second charging terminal 2010 are electrically connected to each other, when the cordless stick cleaner 1000-1 and the station 2000-1 are misaligned with each other or there is a foreign material between charging terminals, the charging terminals may be overheated. For example, when the cordless stick cleaner 1000-1 and the station 2000-1 are not well aligned with each other, contact resistance between the first charging terminal 1010 of the cordless stick cleaner 1000-1 and the second charging terminal 2010 of the station 2000-1 may increase. **In** this case, when the battery 1050 of the cordless stick cleaner 1000-1 is charged, heat may be generated due to abnormally high contact resistance, which may cause damage to a component around a charging terminal or damage to the charging terminal itself.

Accordingly, according to an embodiment of the disclosure, the cordless stick cleaner 1000-1 may calculate a heating value of a charging terminal by applying a charging terminal voltage and current detection algorithm, and may perform an overheating prevention operation when the heating value of the charging terminal exceeds a threshold heating value that is a criterion for overheating. For example, when contact between the first charging terminal 1010 and the second charging terminal 2010 is detected, the cordless stick cleaner 1000-1 may transmit a charge command to the station 2000-1 through wireless communication (e.g., BLE communication). When a voltage is supplied from the station 2000-1 to the cordless stick cleaner 1000-1 according to the charge command, the cordless stick cleaner 1000-1 may obtain a heating value between the first charging terminal 1010 and the second charging terminal 2010. For example, the cordless stick cleaner 1000-1 may detect a first voltage value v2 of the first charging terminal 1010 through the first voltage detection circuit 1100, may obtain a charge current value I_chg of the battery 1050 and a discharge current value I_leak of the battery 1050 from the battery 1050, may receive a second voltage value v1 of the second charging terminal 2010 obtained through the second voltage detection circuit 2100 from the station 2000-1, and may calculate a charging terminal heating value by using the following equation.

$$\text{Charging terminal heating value } P = \text{charging terminal voltage } V * \text{charging terminal current } I$$

$$= [v1 - v2] * [I\_chg + I\_leak]$$

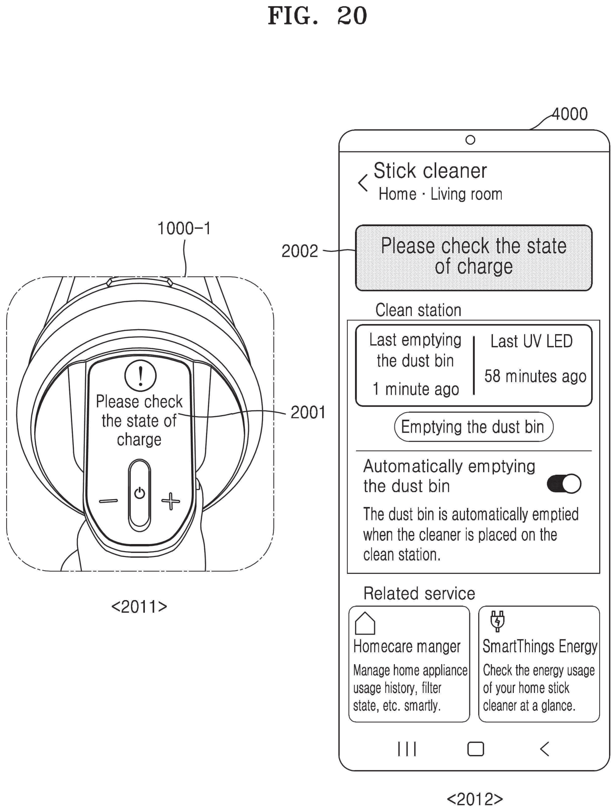

When the charging terminal heating value exceeds the threshold heating value that is a criterion for overheating (overheating reference value), the cordless stick cleaner 1000-1 may output a notification to the user to re-dock the cordless stick cleaner 1000-1. The cordless stick cleaner 1000-1 may output a notification through a display or the user terminal 4000. An operation in which the cordless stick cleaner 1000-1 outputs a notification will be described in more detail with reference to FIG. 20.

FIG. 20 is a view for describing an operation in which the cordless stick cleaner 1000-1 outputs a notification, according to an embodiment of the disclosure.

Referring to 2011 of FIG. 20, when a charging terminal heating value exceeds an overheating reference value, the cordless stick cleaner 1000-1 may output a notification 2001 to a display of the cordless stick cleaner 1000-1. For example, the cordless stick cleaner 1000-1 may output the notification 2001 such as "Please check the state of charge" on the display. In this case, a user may check the notification 2001 output on the display, may separate the cordless stick cleaner 1000-1 from the station 2000-1, and then may put the cordless stick cleaner 1000-1 on the station 2000-1 by aligning charging terminals.

Referring to 2012 of FIG. 20, when a charging terminal heating value exceeds an overheating reference value, the cordless stick cleaner 1000-1 may transmit information indicating that a charging terminal is in an overheating state to the station 2000-1. When the station 2000-1 receives the information indicating that the charging terminal is in an overstating state from the cordless stick cleaner 1000-1, the station 2000-1 may transmit the information indicating that the charging terminal is in an overheating state to the server 3000. In this case, the server 3000 may transmit the information indicating that the charging terminal is in an overheating state to the user terminal 4000. Accordingly, when the user executes an application on the user terminal 4000, the user terminal 4000 may output a notification 2002 such as "Please check the state of charge" on an execution window of the application.

The cordless stick cleaner 1000-1 or the station 2000-1 may transmit the information indicating that the charging terminal is in an overheating state to the user terminal 4000 through device to device (D2D) communication, not through the server 3000.

According to an embodiment of the disclosure, there may be provided the cleaning robot 1000 that prevents damage to a component or a fire from occurring by detecting an overheating state by using a heating value between the first charging terminal 1010 and the second charging terminal 2010 and performing a re-docking operation when a charging terminal is in an overheating state.

The cleaning robot 1000, according to an embodiment of the disclosure, may include: the battery 1050 charged with a voltage supplied from the station 2000; the first charging terminal 1010 for charging the battery 1050 that powers the cleaning robot 1000; the first voltage detection circuit 1100 for detecting a voltage of the first charging terminal 1010; the first communication interface 1080 for communicating with the station 2000; the memory 1002 in which one or more instructions can be stored; and at least one processor. The at least one processor may execute the one or more instructions to detect contact between the first charging terminal 1010 of the cleaning robot 1000 and the second charging terminal 2010 of the station 2000 through the first voltage detection circuit 1100 based on the cleaning robot 1000 docking at the station 2000. The at least one processor may transmit a charge command to the station 2000 through the first communication interface 1080 based on detecting contact between the first charging terminal 1010 and the second charging terminal 2010. The at least one processor may obtain a heating value between the first charging terminal 1010 and the second charging terminal 2010 based on a voltage supplied from the station 2000 to the cleaning robot 1000 according to the charge command. The at least one processor may perform a re-docking operation after the cleaning robot 1000 moves away from the station 2000 by a predetermined distance based on determining that the obtained heating value exceeds a threshold heating value that is a criterion for overheating.

The at least one processor, according to an embodiment of the disclosure, may output a notification indicating that re-docking is performed through a speaker or the user terminal 4000 connected through the server 3000 based on determining that the obtained heating value exceeds the threshold heating value.

The at least one processor, according to an embodiment of the disclosure, may determine that the first charging terminal 1010 of the cleaning robot 1000 and the second charging terminal 2010 of the station 2000 contact each other based on determining that a voltage value detected through the first voltage detection circuit 1100 is equal to or greater than a first threshold voltage value.

The at least one processor, according to an embodiment of the disclosure, may obtain a heating value between the first charging terminal 1010 and the second charging terminal 2010 based on a voltage value between the first charging terminal 1010 and the second charging terminal 2010, a discharge current value of the battery 1050, and a charge current value of the battery 1050.

The at least one processor, according to an embodiment of the disclosure, may measure a first voltage value of the first charging terminal 1010 through the first voltage detection circuit 1100. The at least one processor may receive information about a second voltage value of the second charging terminal 2010 from the station 2000. The at least one processor may obtain a difference between the first voltage value of the first charging terminal 1010 and the second voltage value of the second charging terminal 2010 as the voltage value between the first charging terminal 1010 and the second charging terminal 2010.

The at least one processor, according to an embodiment of the disclosure, may transmit a signal for requesting the second voltage value of the second charging terminal 2010 to the station 2000 based on determining that a voltage value detected through the first voltage detection circuit 1100 after transmitting the charge command is equal to or greater than a second threshold voltage value. The at least one processor may receive the information about the second voltage value of the second charging terminal 2010 from the station 2000.

The second threshold voltage value, according to an embodiment of the disclosure, may be greater than the first threshold voltage value for detecting contact between the first charging terminal 1010 and the second charging terminal 2010.

The at least one processor, according to an embodiment of the disclosure, may transmit a signal for requesting the second voltage value of the second charging terminal 2010 to the station 2000 at a predetermined time interval.

The heating value between the first charging terminal and the second charging terminal, according to an embodiment of the disclosure, may vary according to a state of charge of the battery 1050.

The at least one processor, according to an embodiment of the disclosure, may obtain a first current value detected through a current detection circuit before charging starts after docking as the discharge current value of the battery 1050. The at least one processor may obtain a second current value detected through the current detection circuit after the charging starts as the charge current value of the battery 1050.

When the current detection circuit is included in the battery 1050, the at least one processor, according to an embodiment of the disclosure, may obtain the charge current value of the battery 1050 and the discharge current value of the battery 1050 from the battery 1050.

The at least one processor, according to an embodiment of the disclosure, may transmit the charge command to the station 2000 through wireless communication at a predetermined time interval based on determining that the obtained heating value is equal to or lower than the threshold heating value.

A cordless vacuum cleaner, such as a cordless stick cleaner 1000-1, according to an embodiment of the disclosure, may be configured to dock at a station 2000-1. The cordless vacuum cleaner can include a first charging terminal configured to charge a battery that powers the cordless vacuum cleaner, a first voltage detection circuit configured to detect a voltage of the first charging terminal, a first communication interface configured to communicate with the station 2000-1, a memory configured to store one or more instructions, and at least one processor configured to execute the one or more instructions to perform a plurality of operations. The operations include detecting contact between the first charging terminal of the cordless vacuum cleaner and a second charging terminal of the station 2000-1 through the first voltage detection circuit based on the cordless vacuum cleaner docking at the station 2000-1, transmitting a charge command to the station 2000-1 through the first communication interface based on detecting contact between the first charging terminal and the second charging terminal, obtaining a heating value between the first charging terminal and the second charging terminal based on a voltage supplied from the station 2000-1 to the cordless vacuum cleaner according to the charge command, and performing an overheating prevention operation based on determining that the obtained heating value exceeds a threshold heating value that is a criterion for overheating.

An overheating detection method of the cleaning robot 1000 including the battery 1050 charged with a voltage supplied from the station 2000, according to an embodiment of the disclosure, may include: detecting contact between the first charging terminal 1010 of the cleaning robot 1000 and the second charging terminal 2010 of the station 2000 through the first voltage detection circuit 1100 based on the cleaning robot 1000 docking at the station 2000, transmitting a charge command to the station 2000 through the first communication interface 1080 of the cleaning robot 1000 based on detecting contact between the first charging terminal 1010 and the second charging terminal 2010, obtaining a heating value between the first charging terminal 1010 and the second charging terminal 2010 based on a voltage supplied from the station 2000 to charge the battery 1050 of the cleaning robot 1000 according to the charge command, and performing a re-docking operation after the cleaning robot 1000 moves away from the station 2000 by a predetermined distance based on determining that the obtained heating value exceeds a threshold heating value that is a criterion for overheating.

The overheating detection method of the cleaning robot 1000, according to an embodiment of the disclosure, may include outputting a notification indicating that re-docking is performed through a speaker or the user terminal 4000 connected through the server 3000 based on determining that the obtained heating value exceeds the threshold heating value.

The detecting of the contact between the first charging terminal 1010 of the cleaning robot 1000 and the second charging terminal 2010 of the station 2000, according to an embodiment of the disclosure, may include determining that the first charging terminal 1010 of the cleaning robot 1000 and the second charging terminal 2010 of the station 2000 contact each other based on determining that a voltage value detected through the first voltage detection circuit 1100 is equal to or greater than a first threshold voltage value.

The obtaining of the heating value between the first charging terminal 1010 and the second charging terminal 2010, according to an embodiment of the disclosure, may include obtaining the heating value between the first charging terminal 1010 and the second charging terminal 2010 based on a voltage value between the first charging terminal 1010 and the second charging terminal 2010, a discharge current value of the battery 1050, and a charge current value of the battery 1050.

The obtaining of the heating value between the first charging terminal 1010 and the second charging terminal 2010, according to an embodiment of the disclosure, may include: measuring a first voltage value of the first charging terminal 1010 through the first voltage detection circuit 1100; receiving information about a second voltage value of the second charging terminal 2010 from the station 2000; and obtaining a difference between the first voltage value of the first charging terminal 1010 and the second voltage value of the second charging terminal 2010 as a voltage value between the first charging terminal 1010 and the second charging terminal 2010.

The receiving of the information about the second voltage value of the second charging terminal 2010, according to an embodiment of the disclosure, may include: transmitting a signal for requesting the second voltage value of the second charging terminal 2010 to the station 2000 based on determining that a voltage value detected through the first voltage detection circuit 1100 after transmitting the charge command is equal to or greater than a second threshold voltage value; and receiving the information about the second voltage value of the second charging terminal 2010 from the station 2000. The second threshold voltage value, according to an embodiment of the disclosure, may be greater than the first threshold voltage value for detecting contact between the first charging terminal 1010 and the second charging terminal 2010.

The transmitting of the signal for requesting the second voltage value of the second charging terminal 2010, according to an embodiment of the disclosure, may include transmitting a signal for requesting the second voltage value of the second charging terminal 2010 to the station 2000 at a predetermined time interval.

The overheating detection method of the cleaning robot 1000, according to an embodiment of the disclosure, may include: obtaining a first current value detected through a current detection circuit before charging starts after docking as a discharge current value of the battery 1050; and obtaining a second current value detected through the current detection circuit after charging starts as a charge current value of the battery 1050.

A machine-readable storage medium may be provided as a non-transitory storage medium. Here, 'non-transitory' means that the storage medium does not include a signal (e.g., an electromagnetic wave) and is tangible, but does not distinguish whether data is stored semi-permanently or temporarily in the storage medium. For example, the 'non-transitory storage medium' may include a buffer in which data is temporarily stored.

According to an embodiment of the disclosure, methods according to various embodiments of the disclosure may be provided in a computer program product. The computer program product may be a product purchasable between a seller and a purchaser. The computer program product may be distributed in a form of machine-readable storage medium (e.g., a compact disc read-only memory (CD-ROM) or a universal serial bus (USB) flash drive), or distributed (e.g., downloaded or uploaded) through an application store or directly or online between two user devices (e.g., smartphones). When distributed online, at least part of the computer program product (e.g., a downloadable application) may be temporarily generated or at least temporarily stored in a machine-readable storage medium, such as a memory of a server of a manufacturer, a server of an application store, or a relay server.

**Claims**

1. A cleaning robot (1000) configured to dock at a station (2000), the cleaning robot (1000) comprising:

   a first charging terminal (1010) configured to charge a battery that powers the cleaning robot;
   a first voltage detection circuit (1100) configured to detect a voltage of the first charging terminal;
   a first communication interface (1080) configured to communicate with the station;
   a memory (1002) configured to store one or more instructions; and
   at least one processor configured to execute the one or more instructions to perform a plurality of operations comprising:

   detecting contact between the first charging terminal of the cleaning robot and a second charging terminal of the station through the first voltage detection circuit based on the cleaning robot docking at the station;
   transmitting a charge command to the station through the first communication interface based on detecting contact between the first charging terminal and the second charging terminal;
   obtaining a heating value between the first charging terminal and the second charging terminal based on a voltage supplied from the station to the cleaning robot according to the charge command; and
   performing a re-docking operation after the cleaning robot moves away from the station by a predetermined distance based on determining that the obtained heating value exceeds a threshold heating value that is a criterion for overheating.

2. The cleaning robot of claim 1, wherein the at least one processor is further configured to execute the one or more instructions to output a notification indicating that re-docking is performed through a speaker of the cleaning robot or a user terminal (4000) connected through a server (3000)based on determining that the obtained heating value exceeds the threshold heating value.

3. The cleaning robot of claim 1, wherein the at least one processor is further configured to execute the one or more instructions to determine that the first charging terminal of the cleaning robot and the second charging terminal of the station contact each other based on determining that a voltage value detected through the first voltage detection circuit is equal to or greater than a first threshold voltage value.

4. The cleaning robot of claim 1, wherein the at least one processor is further configured to execute the one or more instructions to obtain a heating value between the first charging terminal and the second charging terminal by multiplying a voltage value between the first charging terminal and the second charging terminal by a sum of a discharge current value of the battery and a charge current value of the battery.

5. The cleaning robot of claim 4, wherein the at least one processor is further configured to execute the one or more instructions to:

   measure a first voltage value of the first charging terminal through the first voltage detection circuit;

receive information about a second voltage value of the second charging terminal from the station; and obtain a difference between the first voltage value of the first charging terminal and the second voltage value of the second charging terminal as the voltage value between the first charging terminal and the second charging terminal.

6. The cleaning robot of claim 5, wherein the at least one processor is further configured to execute the one or more instructions to:

transmit a signal for requesting the second voltage value of the second charging terminal to the station based on determining that a voltage value detected through the first voltage detection circuit after transmitting the charge command is equal to or greater than a second threshold voltage value; and receive the information of the second voltage value of the second charging terminal from the station.

7. The cleaning robot of claim 6, wherein the second threshold voltage value is greater than a first threshold voltage value for detecting contact between the first charging terminal and the second charging terminal.

8. The cleaning robot of claim 6, wherein the at least one processor is further configured to execute the one or more instructions to transmit a signal for requesting the second voltage value of the second charging terminal to the station at a predetermined time interval.

9. The cleaning robot of claim 4, wherein the heating value between the first charging terminal and the second charging terminal varies according to a state of charge of the battery.

10. The cleaning robot of claim 4, wherein the at least one processor is further configured to execute the one or more instructions to:

obtain a first current value detected through a current detection circuit before charging starts after docking as the discharge current value of the battery; and obtain a second current value detected through the current detection circuit after the charging starts as the charge current value of the battery.

11. The cleaning robot of claim 10, wherein the at least one processor is further configured to execute the one or more instructions to, when the current detection circuit is included in the battery, obtain the charge current value of the battery and the discharge current value of the battery from the battery.

12. The cleaning robot of claim 1, wherein the at least one processor is further configured to execute the one or more instructions to transmit the charge command to the station through wireless communication at a predetermined time interval based on determining that the obtained heating value is equal to or lower than the threshold heating value.

13. An overheating detection method of a cleaning robot at a station, the overheating detection method comprising:

detecting contact between a first charging terminal of the cleaning robot and a second charging terminal of the station through a first voltage detection circuit of the cleaning robot based on the cleaning robot docking at the station (S610); transmitting a charge command to the station through a first communication interface of the cleaning robot based on detecting contact between the first charging terminal and the second charging terminal (S620); obtaining a heating value between the first charging terminal and the second charging terminal based on a voltage supplied from the station to charge a battery of the cleaning robot according to the charge command (S630); and performing a re-docking operation after the cleaning robot moves away from the station by a predetermined distance based on determining that the obtained heating value exceeds a threshold heating value that is a criterion for overheating (S650).

14. The overheating detection method of claim 13, further comprising outputting a notification indicating that re-docking is performed through a speaker of the cleaning robot or a user terminal connected through a server based on determining that the obtained heating value exceeds the threshold heating value.

15. The overheating detection method of claim 13, wherein the detecting of the contact between the first charging terminal of the cleaning robot and the second charging terminal of the station comprises determining that the first charging terminal of the cleaning robot and the second charging terminal of the station contact each other based on determining that a voltage value detected through the first voltage detection circuit is equal to or greater than a first threshold voltage value.

# FIG. 1

DOCKING

MISALIGNMENT: OVERHEATING

<10-1>

<10-2>

EP 4 728 949 A1

# FIG. 2

TEMPERATURE OF CHARGING TERMINAL WHEN MISALIGNED

[TEMPERATURE]

[UNIT : sec]

# FIG. 3A

FIG. 3B

**FIG. 4**

CLEANING ROBOT — 1000

FIRST USER INTERFACE — 1070

1040 CAMERA

1071 FIRST INPUT INTERFACE

1073 FIRST OUTPUT INTERFACE

1002 FIRST MEMORY

BATTERY — 1050

1053 BATTERY CELL ARRAY

1055 BATTERY CONTROLLER

1020 SENSOR UNIT

1001 FIRST PROCESSOR

1080 FIRST COMMUNICATION INTERFACE

UART

WIRELESS

1062 MOVING ASSEMBLY

1063 CLEANING ASSEMBLY

1100 FIRST VOLTAGE DETECTION CIRCUIT

1010 FIRST CHARGING TERMINAL

1111 FIRST SWITCH

TERMINAL CONTACT

STATION — 2000

2300 SECOND COMMUNICATION INTERFACE

2100 SECOND VOLTAGE DETECTION CIRCUIT

2010 SECOND CHARGING TERMINAL

UART

2200 SECOND PROCESSOR

2410 SECOND SWITCH

2400 POWER CONVERSION DEVICE

10 INPUT POWER

2500 SECOND USER INTERFACE

2250 SECOND MEMORY

EP 4 728 949 A1

## FIG. 5

EP 4 728 949 A1

POWER CONVERSION DEVICE (2400)

INPUT POWER (10)

EMI FILTER 11

RECTIFIER 12

DC LINK CAPACITOR 13

SWITCH 40

PWM CONTROLLER 30

TRANSFORMER (20)

SECONDARY AC VOLTAGE

SECONDARY RECTIFIER 22

SECONDARY DC LINK CAPACITOR 23

SECONDARY EMI FILTER 21

17v

CC/CV IC 24

CC

CV

FEEDBACK CIRCUIT 25

## FIG. 6

START

DETECT CONTACT BETWEEN FIRST CHARGING TERMINAL OF CLEANING ROBOT AND SECOND CHARGING TERMINAL OF STATION THROUGH FIRST VOLTAGE DETECTION CIRCUIT — S610

TRANSMIT CHARGE COMMAND TO STATION — S620

OBTAIN HEATING VALUE BETWEEN FIRST CHARGING TERMINAL AND SECOND CHARGING TERMINAL — S630

HEATING VALUE > THRESHOLD HEATING VALUE ? — S640

NO

YES

PERFORM RE-DOCKING OPERATION — S650

END

FIG. 7

2000

STATION

2400
Adaptor (17.54V)

2410
Switch : off

8V

2010
+

STATION TERMINAL VOLTAGE (v1) = 8V

2200
SECOND PROCESSOR

2010
−

IR TX

CHARGING TERMINAL CONTACT RESISTANCE
R1

CHARGING TERMINAL VOLTAGE
V

R2

1000

CLEANING ROBOT

1010
+
CLEANING ROBOT TERMINAL VOLTAGE (v2)

1001
FIRST PROCESSOR

v2_sense

R3

R4

1100

1050
BAT

1010
−

IR RX

[CHECK WHETHER THERE IS CONTACT BETWEEN TERMINALS]

# FIG. 8

**STATION** 2000

2400
Adaptor (17.54V)

2410
Switch : on

8V

2010

STATION TERMINAL
VOLTAGE (v1) = 17.54

2200
SECOND PROCESSOR

2010

IR TX

CHARGING
TERMINAL
CONTACT
RESISTANCE
R1

CHARGING
TERMINAL
VOLTAGE
V

R2

**CLEANING ROBOT** 1000

1010
CLEANING ROBOT TERMINAL
VOLTAGE (v2)=17.54

1001
FIRST PROCESSOR

v2_sense

R3

R4

1100

1050
BAT

1010

IR RX

[CHARGE BATTERY]

## FIG. 9

EQUATION 1 : CHARGING TERMINAL VOLTAGE V = STATION TERMINAL VOLTAGE V1 – CLEANING ROBOT TERMINAL VOLTAGE V2
EQUATON 2 : CHARGING TERMINAL CURRENT I = I_chg (VARIABLE) + I_leak (FIXED)
EQUATION 3: CHARGING TERMINAL HEATING VALUE P = CHARGING TERMINAL VOLTAGE V * CHARGING TERMINAL CURRENT I

# FIG. 10

[NORMAL DOCKING] CHARGING TERMINAL VOLTAGE/CURRENT/HEATING VALUE CURVE

[UNIT : mA/mV]

[UNIT : mW]

MAXIMUM HEATING VALUE : 711mW

101

[UNIT : sec]

Y-axis (left, mA/mV): 3000, 2500, 2000, 1500, 1000, 500, 0

Y-axis (right, mW): 800, 700, 600, 500, 400, 300, 200, 100, 0

X-axis: 11, 647, 1283, 1919, 2555, 3191, 3827, 4463, 5099, 5735, 6371, 7007, 7643, 8279, 8915, 9551, 10187, 10823, 11459

———— VOLTAGE(mV)    —·—·— CURRENT(mA)    ———— HEATING VALUE(mW)

| STATE | HEATING VALUE |
| --- | --- |
| NORMAL HEATING STATE | 0mW~711mW |
| OVERHEATING STATE | >711mW |

37

FIG. 11

[ABNORMAL DOCKING] CHARGING TERMINAL VOLTAGE/CURRENT/HEATING VALUE CURVE

# FIG. 12

CLEANING ROBOT — 1000

STATION — 2000

PERFORM DOCKING OPERATION — S1210

DETERMINE WHETHER CHARGING TERMINALS CONTACT — S1220

No

YES

STOP MOVING — S1230

TRANSMIT CHARGE COMMAND (BOOST COMMAND) — S1240

RECEIVE CHARGE COMMAND (BOOST COMMAND) — S1250

INCREASE VOLTAGE BY TURNING ON SECOND SWITCH — S1260

DETERMINE WHETHER VOLTAGE IS BOOSTED — S1270

NO

YES

REQUEST INFORMATION ABOUT SECOND VOLTAGE VALUE OF SECOND CHARGING TERMINAL — S1280

TRANSMIT INFORMATION ABOUT SECOND VOLTAGE VALUE OF SECOND CHARGING TERMINAL — S1290

<go S630>

39

# FIG. 13

START

↓

DETECT OVERHEATING BY COMPARING TERMINAL
HEATING VALUE WITH THRESHOLD HEATING VALUE — S1310

↓

OUTPUT NOTIFICATION — S1320

↓

PERFORM RE-DOCKING OPERATION — S1330

↓

END

# FIG. 14

2000

1401

REDOCKING IS
PERFORMED DUE TO
MISALIGNMENT

RE-DOCKING

1000

# FIG. 15

START

TRANSMIT CHARGE COMMAND (BOOST COMMAND) TO STATION —— S1510

DETERMINE WHETHER VOLTAGE IS BOOSTED —— S1520

NO

YES

DETERMINE WHETHER CONTACT BETWEEN CHARGING TERMINALS IS NOT DETECTED —— S1530

YES → PERFORM RE-DOCKING OPERATION —— S1540

NO

TRANSMIT SECOND VOLTAGE VALUE REPLY COMMAND TO STATION —— S1550

OBTAIN SECOND VOLTAGE VALUE —— S1560

OBTAIN HEATING VALUE —— S1570

<Go S640>

# FIG. 16

<1610>

2000

1601

1000

<1620>

2000

RE-DOCKING  1000

FIG. 17

EP 4 728 949 A1

# FIG. 18

Cleaning robot
Living room

1801 — Re-docking is performed due to misalignment

Motor filter ⓘ
Good
Last cleaned : 3 months ago
Buy

Exhaust filter ⓘ
15 % left
0    15%                    100%
Reset filter usage
Buy

Dust bag (Clean station) ⓘ
Cleaning needed
Last cleaned : 3 months ago

# FIG. 19

CHARGING TERMINAL (2010)

1000-1

2000-1

<1910>

1000-1

COMMUNICATION

2000-1

MISALIGNMENT: OVERHEATING

<1920>

EP 4 728 949 A1

# FIG. 20

4000

1000-1

2002

Stick cleaner
Home · Living room

Please check the state
of charge

Clean station

Last emptying
the dust bin

1 minute ago

Last UV LED

58 minutes ago

Emptying the dust bin

2001

Please check
the state of
charge

Automatically emptying
the dust bin

The dust bin is automatically emptied
when the cleaner is placed on the
clean station.

Related service

Homecare manger

Manage home appliance
usage history, filter
state, etc. smartly.

SmartThings Energy

Check the energy usage
of your home stick
cleaner at a glance.

<2011>

<2012>

## INTERNATIONAL SEARCH REPORT

| International application No. |
|---|
| **PCT/KR2024/015205** |

**A.  CLASSIFICATION OF SUBJECT MATTER**

**A47L 9/28**(2006.01)i; **H02J 7/00**(2006.01)i; **G01R 19/165**(2006.01)i; **G01R 19/30**(2006.01)i

According to International Patent Classification (IPC) or to both national classification and IPC

**B.  FIELDS SEARCHED**

Minimum documentation searched (classification system followed by classification symbols)

A47L 9/28(2006.01); A47L 9/00(2006.01); B25J 13/08(2006.01); G05D 1/02(2006.01); H01M 10/46(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 청소 로봇(cleaning robot), 스테이션(station), 도킹(dock), 충전(charge), 과발열(overheating), 전압(voltage), 전류(current), 단자(terminal), 온도(temperature)

**C.  DOCUMENTS CONSIDERED TO BE RELEVANT**

| Category* | Citation of document, with indication, where appropriate, of the relevant passages | Relevant to claim No. |
|---|---|---|
| Y | KR 10-1923979 B1 (LG DISPLAY CO., LTD.) 30 November 2018 (2018-11-30)<br>See paragraphs [0024]-[0081] and figures 1-3. | 1-15 |
| Y | KR 10-2012-0049533 A (SAMSUNG ELECTRONICS CO., LTD.) 17 May 2012 (2012-05-17)<br>See paragraphs [0065]-[0076] and figures 1-3. | 1-15 |
| A | JP 2023-523298 A (OMRON CORPORATION) 02 June 2023 (2023-06-02)<br>See paragraphs [0018]-[0049] and figures 1-3. | 1-15 |
| A | JP 2002-360483 A (TOSHIBA TEC CORP.) 17 December 2002 (2002-12-17)<br>See paragraphs [0021]-[0031] and figures 1-7. | 1-15 |
| A | KR 10-2021-0097049 A (BISSELL INC.) 06 August 2021 (2021-08-06)<br>See claim 19 and figure 1. | 1-15 |

☐ Further documents are listed in the continuation of Box C.          ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **09 January 2025** | **09 January 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 728 949 A1

**INTERNATIONAL SEARCH REPORT**
Information on patent family members

International application No.

**PCT/KR2024/015205**

| Patent document cited in search report | | | Publication date (day/month/year) | Patent family member(s) | | | Publication date (day/month/year) |
|---|---|---|---|---|---|---|---|
| KR | 10-1923979 | B1 | 30 November 2018 | KR | 10-2014-0000444 | A | 03 January 2014 |
| KR | 10-2012-0049533 | A | 17 May 2012 | US | 2012-0116588 | A1 | 10 May 2012 |
| | | | | US | 8761939 | B2 | 24 June 2014 |
| JP | 2023-523298 | A | 02 June 2023 | CN | 115552758 | A | 30 December 2022 |
| | | | | DE | 112021002840 | T5 | 23 March 2023 |
| | | | | JP | 7505580 | B2 | 25 June 2024 |
| | | | | US | 2023-0216312 | A1 | 06 July 2023 |
| | | | | WO | 2021-236397 | A1 | 25 November 2021 |
| JP | 2002-360483 | A | 17 December 2002 | | None | | |
| KR | 10-2021-0097049 | A | 06 August 2021 | AU | 2021-200506 | A1 | 12 August 2021 |
| | | | | BR | 102021001506 | A2 | 03 August 2021 |
| | | | | CA | 3107282 | A1 | 29 July 2021 |
| | | | | CN | 113261878 | A | 17 August 2021 |
| | | | | CN | 215348699 | U | 31 December 2021 |
| | | | | EP | 3858208 | A2 | 04 August 2021 |
| | | | | EP | 3858208 | A3 | 13 October 2021 |
| | | | | EP | 3858208 | B1 | 24 July 2024 |
| | | | | JP | 2021-118849 | A | 12 August 2021 |
| | | | | US | 11925306 | B2 | 12 March 2024 |
| | | | | US | 2021-0228039 | A1 | 29 July 2021 |

Form PCT/ISA/210 (patent family annex) (July 2022)